(19) Europäisches Patentamt
European Patent Office
Office européen des brevets

(11) EP 4 626 195 A1

(12) EUROPEAN PATENT APPLICATION

(43) Date of publication:
**01.10.2025 Bulletin 2025/40**

(21) Application number: **25161751.0**

(22) Date of filing: **05.03.2025**

(51) International Patent Classification (IPC):
***H10K 50/852*** *(2023.01)* ***H10K 50/844*** *(2023.01)*
***B41J 2/447*** *(2006.01)* ***B41J 2/45*** *(2006.01)*
***G03G 15/04*** *(2006.01)* ***H10K 59/80*** *(2023.01)*
*H10K 102/00 (2023.01)*

(52) Cooperative Patent Classification (CPC):
**H10K 50/852; G03G 15/04054; H10K 50/8445; H10K 59/8731; H10K 59/876;** G03G 15/326; H10K 2102/351

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2024 JP 2024056295**

(71) Applicant: **CANON KABUSHIKI KAISHA**
**Tokyo 146-8501 (JP)**

(72) Inventors:
- **IWAWAKI, Hironobu**
  **Tokyo, 146-8501 (JP)**
- **YAMADA, Naoki**
  **Tokyo, 146-8501 (JP)**
- **NISHIDE, Yosuke**
  **Tokyo, 146-8501 (JP)**
- **ITO, Kentaro**
  **Tokyo, 146-8501 (JP)**

(74) Representative: **TBK**
**Bavariaring 4-6**
**80336 München (DE)**

# (54) EXPOSURE HEAD AND IMAGE-FORMING APPARATUS

(57) The present disclosure provides an exposure head (28) that can efficiently generate electric charge with a photoreceptor (27) through exposure by an exposure head (28) using an organic light emitting element. The exposure head (28) comprises an organic light emitting element, wherein the organic light emitting element includes a first electrode, a second electrode, an organic compound layer arranged between the first electrode and the second electrode, and a protection layer (125) covering the second electrode. The organic compound layer includes a light emitting layer, and the number of peaks in an exposure spectrum (41) emitted from the exposure head (28) is greater than the number of peaks in a PL spectrum (40) of the light emitting material included in the light emitting layer.

FIG. 4A

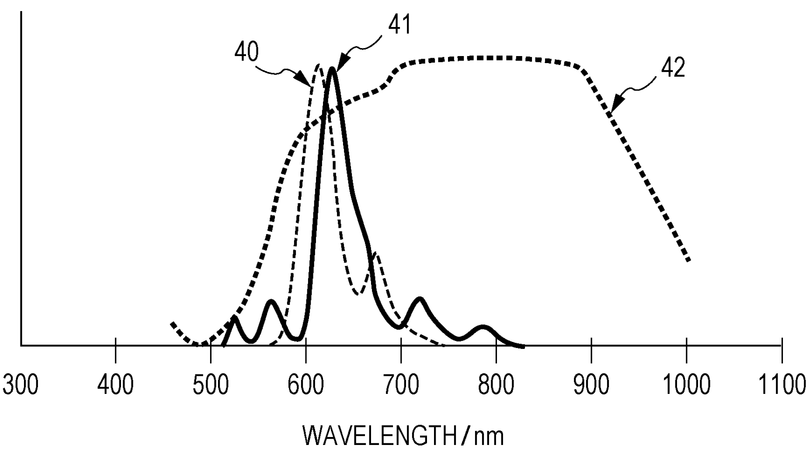


EP 4 626 195 A1

## Description

### BACKGROUND OF THE INVENTION

#### Field of the Invention

The present disclosure relates to an exposure head and an image-forming apparatus.

#### Description of the Related Art

A photosensitive drum (hereinafter, also referred to as "drum-shaped electrophotographic photoreceptor" or "photoreceptor") that is used in an image-forming apparatus adopting an electrophotographic system is generally broadly used as a copier, a facsimile machine, and a printer. Such an electrophotographic apparatus is an image-forming apparatus provided with an exposure head (print head) and includes multiple light emitting elements. The light emitting element may be an LED (light emitting diode) or an organic light emitting element (OLED: organic light emitting diode). The photoreceptor drum is exposed to light emitted from these multiple light emitting elements, and an image corresponding to the latent image formed on the photoreceptor drum is printed on recording paper.

Japanese Patent Laid-Open No. 2022-100479 discloses an exposure head using an organic light emitting element.

However, the exposure head described in Japanese Patent Laid-Open No. 2022-100479 has a bottom-emission structure and is required to be further improved in the efficiency.

### SUMMARY OF THE INVENTION

The present disclosure provides an exposure head that can efficiently generate electric charge with a photoreceptor through exposure by an exposure head using an organic light emitting element, and an image-forming apparatus.

The present disclosure in its first aspect provides an exposure head as specified in claims 1 to 9.

The present disclosure in its second aspect provides an image-forming apparatus as specified in claims 10 to 13.

Further features of the present invention will become apparent from the following description of exemplary embodiments with reference to the attached drawings.

### BRIEF DESCRIPTION OF THE DRAWINGS

Figs. 1A to 1C are diagrams showing examples of the image-forming apparatus of the present disclosure.
Fig. 2 is a diagram showing another example of the image-forming apparatus of the present disclosure.
Fig. 3 is a vertical cross-sectional view illustrating an example of the structure of an organic light emitting element.
Figs. 4A and 4B are graphs showing examples of the spectrum of the exposure head of the present disclosure.
Fig. 5 is a schematic view showing one aspect of a light emission device that can be used in the exposure head of the present embodiment.
Fig. 6A is a schematic perspective view of a head substrate, Fig. 6B is a diagram showing an arrangement of multiple light emitting elements disposed on the head substrate, and Fig. 6C is an enlarged view of a part of Fig. 6B.
Fig. 7 is a diagram showing an example of the layer configuration of the photoreceptor of the present disclosure.

### DESCRIPTION OF THE EMBODIMENTS

The image-forming apparatus of the present disclosure includes a photoreceptor (photosensitive drum) and an exposure head (print head) for exposing the photoreceptor. The exposure head of the present disclosure includes an organic light emitting element (OLED: organic light emitting diode).

Figs. 1A to 1C show examples of the image-forming apparatus of the present disclosure. Fig. 1A is a schematic diagram showing an example of the image-forming apparatus according to an embodiment of the present disclosure. The image-forming apparatus 400 is an image-forming apparatus of an electrophotographic system and includes a photoreceptor 27, an exposure head 28, a charging portion 30, a development portion 31, a transfer unit 32, a convey roller 33, and a fixing unit 35. The photoreceptor 27 is irradiated with light 29 from the exposure head 28 to form an electrostatic latent image on the surface of the photoreceptor 27. This exposure head 28 includes the organic light emitting element. The development portion 31 includes a toner or the like. The charging portion 30 charges the photoreceptor 27. The transfer unit 32 transfers the developed image to a recording medium 34. The convey roller 33 conveys the recording medium 34.

The recording medium 34 is, for example, paper. The fixing unit 35 fixes the image formed on the recording medium 34.

Figs. 1B and 1C are each a diagram showing the exposure head 28 and are each a schematic diagram showing a state where multiple light emitting portions 36 are arranged on a long-length substrate. The arrow 37 is in a direction parallel to the axis of the photoreceptor and represents the column direction in which the organic light emitting element is disposed. This column direction is the same as the direction of the axis about which the photoreceptor 27 rotates. This direction may be referred to as the major-axis direction of the photoreceptor 27.

Fig. 1B shows an aspect of arranging light emitting portions 36 along the major-axis direction of the photoreceptor 27. Fig. 1C shows an aspect that is different from that in Fig. 1B and is an aspect of alternately arranging light emitting portions 36 in a first column and a second column in the column direction. The first column and the second column are arranged at positions different from each other in the row direction. In the first column, multiple light emitting portions 36 are arranged with intervals.

The second column includes light emitting portions 36 at positions corresponding to the intervals between the light emitting portions 36 in the first column. That is, multiple light emitting portions 36 are arranged with intervals also in the row direction. The arrangement of Fig. 1C can also be expressed as, for example, an arrangement in a lattice, an arrangement in a zigzag, or an arrangement in a checkered pattern.

Fig. 2 shows another example of the image-forming apparatus of the present disclosure. Fig. 2 is a diagram showing the overall configuration of the apparatus. The image-forming apparatus is an image-forming apparatus of an electrophotographic system and is composed of a scanner portion 100, an image-forming portion 103, a fixing portion 104, a feeding/conveying portion 105, and a printer controller (not shown) for controlling them.

In the scanner portion 100, a copy put on a copy holder is illuminated to optically read the copy image, and the image is converted into an electric signal to produce image data. In the image-forming portion 103, the photoreceptor drum 102 is rotary-driven, and a charging unit 107 charges the photoreceptor drum 102. An exposure head 106 (in the drawing, 106a, b, c, and d indicate the arrangement of four exposure heads for corresponding to four-color full-color) emits light depending on the image data, and the light emitted from the chip surfaces of the disposed light emitting element group is condensed on the photoreceptor drum 102 by a rod lens array to form an electrostatic latent image. A development unit 108 develops the electrostatic latent image formed on the photoreceptor drum 102 with a toner. The developed toner image is transferred on paper conveyed on a transfer belt 111. The image-forming portion 103 includes four series of image-forming units for performing a series of electrophotographic processes (charging, exposure, development, and transfer) and forms full-color images with cyan (C), magenta (M), yellow (Y), and black (K) aligned in this order in each unit. The four series of image-forming units carry out image-forming operation of magenta, yellow, and black sequentially after a predetermined time has elapsed since the start of image-forming of the cyan station. In the feeding/conveying portion 105, paper is fed from a pre-specified paper feed unit among internal paper feed units 109a and 109b, an external paper feed unit 109c, and a manual paper feed unit 109d, and the fed paper is conveyed to a resist roller 110. The resist roller 110 conveys paper on the transfer belt 111 at the timing when the toner image formed on the image-forming portion 103 is transferred onto the paper. An optical sensor 113 is arranged opposite the transfer belt 111 and detects the position of a test chart printed on the transfer belt 111 for deriving the amount of color deviation between each station. The amount of color deviation derived here is notified to an image controller (not shown) to correct the image position of each color. This control allows a full-color toner image to be transferred onto paper without causing color deviation. The fixing portion 104 is composed of a combination of rollers and includes a built-in heat source such as a halogen heater, and the toner on the paper onto which the toner image has been transferred from the transfer belt 111 is dissolved and fixed with heat and pressure, and the paper is discharged to the outside of the image-forming apparatus by a paper discharge roller 112.

The printer controller (not shown) communicates with an MFP controller (not shown) for controlling the entire MFP to carry out the control depending on the instruction of the controller and to give instruction so as to maintain overall harmony and ensure smooth operation while controlling the conditions of each of the scanner portion 100, the image-forming portion 103, the fixing portion 104, and the feeding/conveying portion 105.

## Exposure head

An example of the configuration of the exposure head adapted to the image-forming apparatus according to the present embodiment will be described. The image-forming apparatus includes a photoreceptor and an exposure head as a part of the configuration. The photoreceptor and the exposure head are arranged so as to face to each other. This exposure head is composed of multiple organic light emitting elements and a lens array. The exposure head may include a plurality of light emitting element columns or may include a single light emitting element column.

## Organic light emitting element

The organic light emitting element includes a first electrode, a second electrode, an organic compound layer arranged between the first electrode and the second electrode, and a protection layer covering the second electrode, and

the organic compound layer includes a light emitting layer. The organic compound layer may further include a first organic compound layer located between the first electrode and the light emitting layer and a second organic compound layer located between the light emitting layer and the second electrode. In this case, the first electrode is a reflection electrode, the second electrode is a light extraction electrode, and the thickness of the first organic compound layer can be smaller than the thickness of the second organic compound layer.

Fig. 3 is a vertical cross-sectional view illustrating an example of the structure of an organic light emitting element. The light emitting element of Fig. 3 includes, on an opaque light-impermeable substrate 1, a positive electrode (reflection electrode) 2, a hole injection layer 3, a hole transport layer 4, a light emitting layer 5, a first electron transport layer 6, a second electron transport layer 7, an electron injection layer 8, and a negative electrode (light extraction electrode) 9 in this order in the lamination direction. Furthermore, the light emitting element includes, as a sealing film, a first protection layer 10, a second protection layer 11, and a third protection layer 12 and includes a microlens (not shown) in some cases. Application of a voltage between both electrodes causes injection of holes from the positive electrode 2 side and electrons from the negative electrode 9 side. The injected holes and electrons are recombined in the light emitting layer 5 to form an excited state, and light is emitted when they return to the ground state. The emitted light is reflected by the reflection electrode 2 and is output from the light extraction electrode 9 side.

In the example of Fig. 3, the positive electrode (reflection electrode) 2 is the first electrode; the hole injection layer 3, the hole transport layer 4, the light emitting layer 5, the first electron transport layer 6, the second electron transport layer 7, and the electron injection layer 8 are the organic compound layers; and the negative electrode (light extraction electrode) 9 is the second electrode. The hole injection layer 3 and the hole transport layer 4 are the first organic compound layers; and the first electron transport layer 6, the second electron transport layer 7, and the electron injection layer 8 are the second organic compound layers.

In the present disclosure, the exposure spectrum emitted from the exposure head is a spectrum having multiple peaks and can be a spectrum having multiple peaks with wide wavelength ranges of somewhat intense light. The present inventors have studied, and it is inferred to as follows. That is, it is inferred that an emission spectrum having multiple peaks efficiently excites the photosensitive layer of the photoreceptor and is excellent in a series of mechanisms for quickly transferring charge to a charge-transporting material, and is therefore one of factors capable of decreasing the residual charge and not reduce the image quality. In particular, a spectrum having multiple peaks with wide wavelength ranges has a width in the optical energy, and thereby can irradiate various excitation energies as excitation light. Accordingly, it is inferred that since excitation of the photosensitive material present in the photosensitive layer causes charge separation in various energy states, the charge transfer becomes easy, leading to a reduction in the residual charge. In contrast, in intense excitation light with a single wavelength, it is inferred that since charge separation is caused in the same energy state, excessive charge that is difficult to transfer is generated and becomes residual charge with high probability.

The present inventors found that an organic light emitting element having a top emission type element structure that can be used in interference of light and uses an impermeable substrate, shown in Fig. 3, is effective in order to realize light having multiple peaks, in particular, intense light having multiple peaks with wide wavelength ranges. In such a structure, a light emission spectrum inherent to a light emitting material can be extracted as a spectrum having multiple peaks in a wider band. Specifically, the film thickness between the light emitting layer 5 and the reflection electrode 2, the film thickness between the light emitting layer 5 and the light extraction electrode 9, and the total organic film thickness can be each an interference thickness that enhances the emission wavelength. In order further enhance the effect, the film thickness of the first protection layer 10, the film thickness of the second protection layer 11, and the film thickness of the third protection layer 12, and the light reflection ratio of the second protection layer 11 may be each optimized. This optimization of the film thicknesses of the protection layers and the reflection ratio allows a short-period light interference structure to be produced, and an emission spectrum inherent to the light emitting material can be extracted as a spectrum with multiple peaks.

In the organic light emitting element, the positive electrode 2 and the negative electrode 9 can constitute an optical resonator structure. The optical resonator structure is constituted, for example, between electrodes, such that the optical distance enhances the light emitted from the light emitting layer. In one example of the structure, the distance from the light emitting layer to the reflective layer on the substrate side is odd number times of $\lambda/4$, where $\lambda$ is the wavelength of light emitted from the light emitting layer.

If manufacturing errors and so on can be acceptable, the optical distance Li can satisfy the following expression 1. The optical distance $L_1$ may be the distance from the light emitting layer to the reflective layer on the substrate side, may be the distance from the light emitting layer to the reflective layer on the light extraction side, or may be the distance from the reflective layer on the substrate side to the reflective layer on the light extraction side.

$$0.7(-\Phi_1/(2\pi) + m_1) \times \lambda \leq 2 \times L_1 \leq 1.2(-\Phi_1/(2\pi) + m_1) \times \lambda \quad \text{Expression 1.}$$

In the expression 1, $\lambda$ is the wavelength of light emitted from the light emitting layer, $\Phi_1$ is a phase shift on the

reflective surface, and $m_1$ is an integer. When there are two reflective surfaces, $\Phi_1$ is the sum of phase shifts.

The negative electrode 9 may be a semi-permeable reflective layer having properties of transmitting part of light reached the surface and reflecting other part of the light (i.e., semi-permeable reflectivity). The semi-permeable reflective electrode is formed of, for example, a simple metal such as magnesium and silver, an alloy mainly composed of magnesium or silver, or an alloy material containing an alkali metal or alkaline earth metal. For example, magnesium-silver, aluminum-lithium, aluminum-magnesium, silver-copper, and zinc-silver can be used. These electrode materials may be used alone or in combination of two or more. The negative electrode 9 may have a single-layer configuration or a multi-layer configuration. In particular, silver can be used, and in order to reduce aggregation of silver, a silver alloy can be used. The ratio of the alloy does not matter as long as the aggregation of silver can be reduced. For example, the ratio of silver : another metal may be, for example, 1 : 1 or 3 : 1. The other metal can be magnesium.

In order to obtain an optimum spectrum shape, the film thickness of the first protection layer 10 is preferably from 100 nm to 3000 nm and more preferably from 500 nm to 2000 nm, the film thickness of the second protection layer 11 is preferably from 10 nm to 500 nm and more preferably from 50 nm to 300 nm, and the film thickness of the third protection layer 12 is preferably from 100 nm to 2000 nm and more preferably rom 200 nm to 1000 nm. The protection layer is not limited to a three-layer structure and may have a multi-layer structure of four or more layers. In a multi-layer structure, the interference period is easily optimized. The protection layer can include silicon nitride and may include a layer including aluminum oxide on a layer including silicon nitride.

In order to efficiently irradiate the photoreceptor with a high luminance emission spectrum emitted from the light emitting layer 5, the absorption loss that occurs on the optical path from the light emitting layer 5 to the photoreceptor surface can be reduced. First, it is desirable not to be absorbed by a carrier transport layer other than the light emitting layer 5. In particular, since an emission spectrum passes through the hole transport layer 4 present between the reflection electrode (positive electrode) 2 and the light emitting layer 5 at least twice, absorption cannot be present. Secondly, it is desirable not to be absorbed also by the protection layer and microlens present on the light extraction electrode 9. Thirdly, it is desirable not to be absorbed also by the lens array disposed between the organic light emitting element and the photoreceptor. Spectrum of exposure head

The photoreceptor is composed of various functional layers. In particular, a layer that plays a role in forming a charge-separated state by the exposed light is a charge generation layer. In the charge generation layer, the charge-generating material is an important material that plays a role in photoelectron conversion. Examples of the charge-generating material include an azo pigment, a perylene pigment, an anthraquinone derivative, an anthanthrone derivative, a dibenzpyrenequinone derivative, a pyranthrone derivative, a quinone pigment, an indigoid pigment, a phthalocyanine pigment, and a perinone pigment. Among them, the charge-generating material can be a phthalocyanine pigment. The phthalocyanine pigment may be oxytitanium phthalocyanine, chlorogallium phthalocyanine, or hydroxygallium phthalocyanine.

Recently, an organic light emitting element has been proposed as an exposure light source for a photoreceptor. A general organic light emitting element is a bottom emission type organic light emitting element of which the manufacturing process is recognized to be relatively simple. In this case, the emission spectrum is extracted from the transparent substrate side where a pixel circuit for driving is present, which leads to a risk of reduced light utilization efficiency. Furthermore, since the bottom emission type organic light emitting element is difficult to have an interference thickness structure that enhances the light emission, the exposure efficiency as an exposure light source may not be very high. One method for solving this problem is, as described above, an organic light emitting element that emits intense light having a wide wavelength range. The organic light emitting element can be a top emission type organic light emitting element which can use interference of light. If light is in a wide wavelength range, light energy has a certain range. In such a case, it is believed that specific excitation energy does not concentrate in a charge-generating material that absorbs light, which leads to a reduction in the excess charge. It is believed that not only a certain conduction path but also various conduction paths occur, which efficiently separates the charge.

Figs. 4A and 4B are graphs showing examples of the spectrum of the exposure head of the present disclosure. In Figs. 4A and 4B, 40 indicates a PL spectrum of the light emitting material included in a light emitting layer, 41 indicates an exposure spectrum emitted from an exposure head, 42 indicates an optical absorption spectrum of a photoreceptor, 43 indicates an optical absorption spectrum of a first organic compound layer, and 44 indicates an optical absorption spectrum of a second organic compound layer.

As shown in Fig. 4A, the number of peaks in the exposure spectrum 41 is greater than the number of peaks in the PL spectrum 40 of the light emitting material. In Fig. 4A, the PL spectrum 40 of the light emitting material has two peaks, and the exposure spectrum 41 has five or more peaks.

As shown in Fig. 4A, the all peaks of the exposure spectrum 41 can overlap the optical absorption spectrum 42 of the photoreceptor. When multiple peaks of the exposure spectrum 41 poorly overlap the optical absorption spectrum 42 of the photoreceptor, the charge separation efficiency decreases, and higher intense light may be required. Accordingly, the electrical load on the organic light emitting element may increase.

As shown in Figs. 4A and 4B, the longest peak wavelength in the optical absorption spectrum 44 of the second

organic compound layer can be farther from the maximum light emission peak wavelength of the PL spectrum 40 of a light emitting material than the longest peak wavelength in the optical absorption spectrum 43 of the first organic compound layer is.

As shown in Figs. 4A and 4B, the maximum light emission peak wavelength in the PL spectrum 40 of a light emitting material can be closer to the maximum absorption peak wavelength of the optical absorption spectrum 42 of the photoreceptor in the visible light region than the longest peak wavelength in the optical absorption spectrum 43 of the first organic compound layer or the longest peak wavelength in the optical absorption spectrum 44 of the second organic compound layer is. Furthermore, as shown in Fig. 4B, the maximum light emission peak wavelength of the exposure spectrum 41 can be closer to the maximum absorption peak wavelength of the optical absorption spectrum of the photoreceptor in the visible light region than the longest peak wavelength in the optical absorption spectrum 43 of the first organic compound layer or the longest peak wavelength in the optical absorption spectrum 44 of the second organic compound layer is.

Furthermore, it is desirable to have as little overlap as possible between the exposure spectrum 41 and the absorption spectrum of the protection layer. When the overlap with the absorption spectrum of the protection layer is large, the exposure spectrum 41 is highly influenced by the interference of light occurring in the protection layer, which may significantly decrease the spectral intensity.

Similarly to this, it is desirable to have as little overlap as possible between the exposure spectrum 41 and the absorption spectrum of each of the layers constituting the organic compound layer.

Layer configuration of organic light emitting element

Specifically, examples of the element configuration of the organic light emitting element of the present embodiment include multilayer type element configuration in which any of the electrode layers shown in the following (1) to (6) and an organic compound layer are sequentially laminated on a substrate.

In every element configuration, the organic compound layer invariably includes a light emitting layer including a light emitting material.

(1) positive electrode/light emitting layer/negative electrode;
(2) positive electrode/hole transport layer/light emitting layer/electron transport layer/negative electrode;
(3) positive electrode/hole transport layer/light emitting layer/electron transport layer/electron injection layer/negative electrode;
(4) positive electrode/hole injection layer/hole transport layer/light emitting layer/electron transport layer/negative electrode;
(5) positive electrode/hole injection layer/hole transport layer/light emitting layer/electron transport layer/electron injection layer/negative electrode; and
(6)positive electrode/hole transport layer/electrode blocking layer/light emitting layer/hole blocking layer/electron transport layer/negative electrode.

However, these examples of the element configuration are merely very basic element configurations and are not limited thereto. For example, a variety of layer configurations, e.g., an insulating layer, an adhesive layer, or an interference layer is disposed at the interface between an electrode and an organic compound layer, an electron transport layer or a hole transport layer is constituted of two layers having different ionization potentials, or a light emitting layer is constituted of two layers of different light emitting materials, can be adopted.

Compound to be used in organic light emitting element

In the organic light emitting element according to the present embodiment, existing known low molecular and high molecular hole injection or hole transport compounds, compounds becoming hosts, light emitting compounds, and electron injection or electron transport compound can be additionally used as needed. Examples of these compounds will be mentioned below.

The hole injection or transport material can be a material with high hole mobility such that injection of holes from the positive electrode is easy and the injected holes can be transported to the light emitting layer. In addition, in order to reduce the film quality degradation such as crystallization in the organic light emitting element, a material having a high glass transition temperature may be used. Examples of low molecular and high molecular materials having hole injection or transport performance include a triarylamine derivative, an arylcarbazole derivative, a phenylenediamine derivative, a stilbene derivative, a phthalocyanine derivative, a porphyrin derivative, poly(vinylcarbazole), poly(thiophene), and other conductive polymers. Furthermore, the above-mentioned hole injection or transport material can be suitably used also in an electron blocking layer. Examples of the compound that is used as the hole injection or transport material are shown

below, but are not limited thereto.

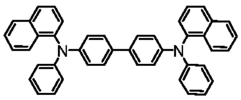

HT1

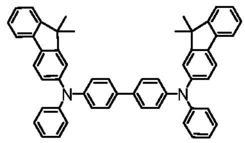

HT2

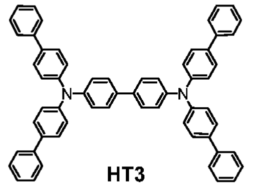

HT3

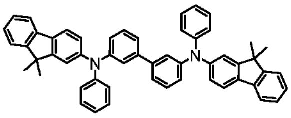

HT4

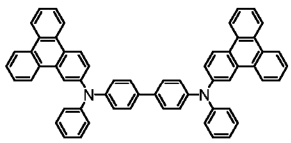

HT5

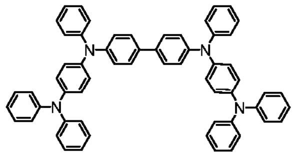

HT6

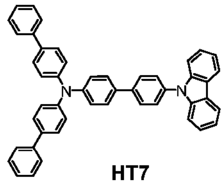

HT7

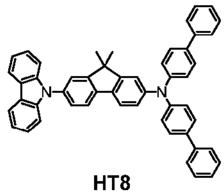

HT8

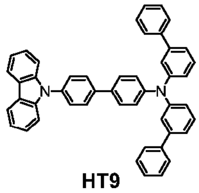

HT9

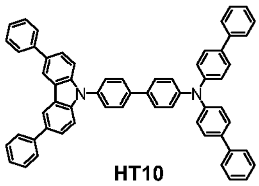

HT10

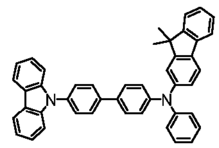

HT11

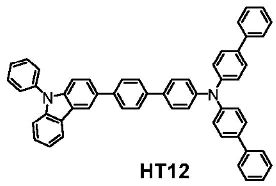

HT12

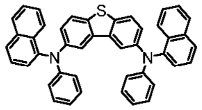

HT13

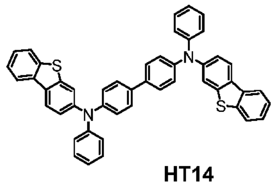

HT14

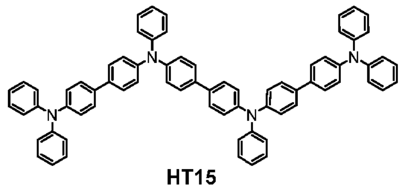

HT15

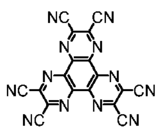

HT16

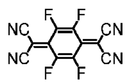

HT17

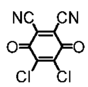

HT18

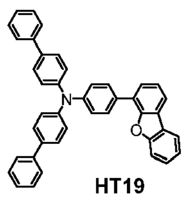

HT19

Examples of the light emitting material mainly related to the light emitting function include a fused ring compound (e.g., a fluorene derivative, a naphthalene derivative, a pyrene derivative, a perylene derivative, a tetracene derivative, an anthracene derivative, and rubrene), a quinacridone derivative, a coumarin derivative, a stilbene derivative, an organoaluminum complex such as tris(8-quinolinolato)aluminum, an iridium complex, a platinum complex, a rhenium complex, a copper complex, an europium complex, a ruthenium complex, and polymer derivatives such as a poly(phenylenevinylene) derivative, a poly(fluorene) derivative, and a poly(phenylene) derivative. Examples of the compound that is used as the light emitting material are shown below, but are not limited thereto.

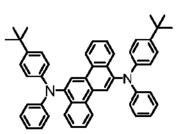
BD1
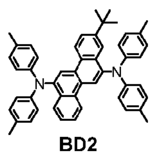
BD2
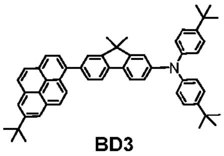
BD3
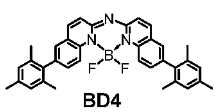
BD4

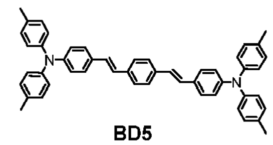
BD5
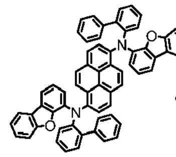
BD6
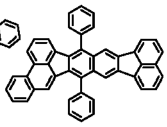
BD7
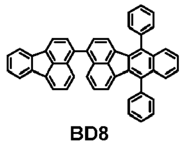
BD8

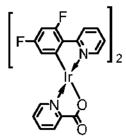
BD9
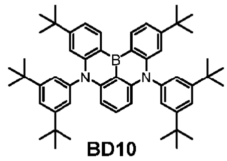
BD10

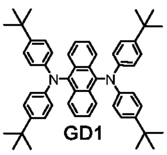
GD1
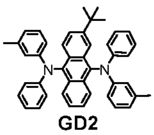
GD2
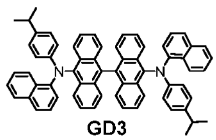
GD3
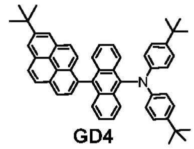
GD4

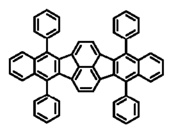
GD5
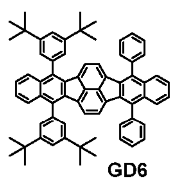
GD6
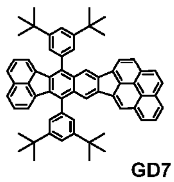
GD7
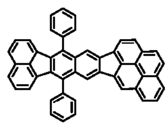
GD8

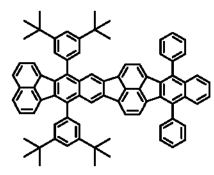
GD9
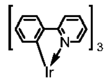
GD10
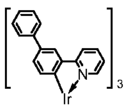
GD11
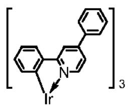
GD12
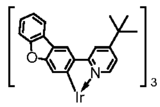
GD13

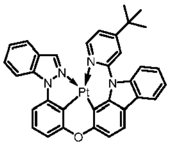
GD14
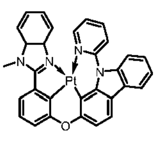
GD15
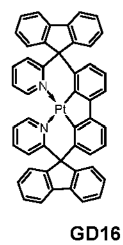
GD16
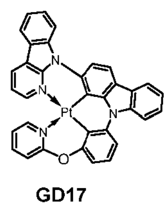
GD17
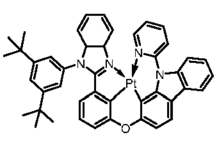
GD18

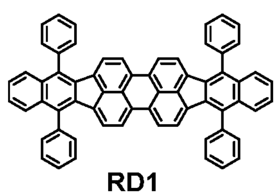
RD1
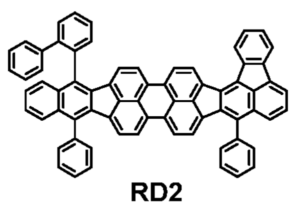
RD2
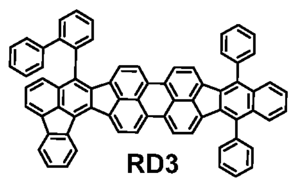
RD3

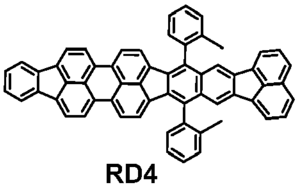

RD4

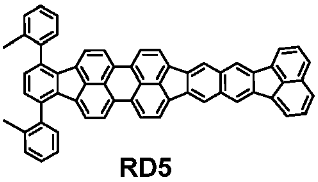

RD5

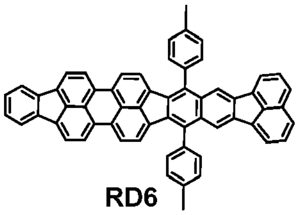

RD6

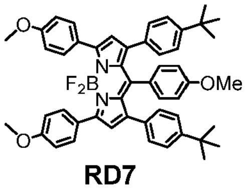

RD7

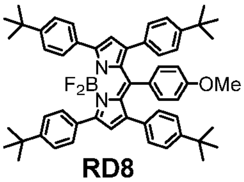

RD8

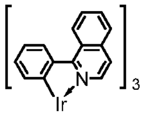

RD9

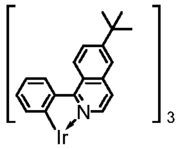

RD10

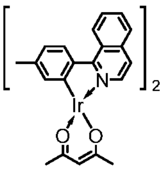

RD11

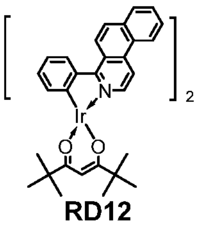

RD12

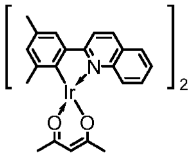

RD13

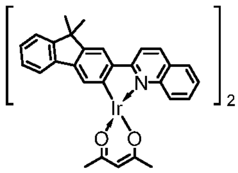

RD14

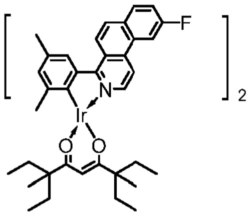

RD15

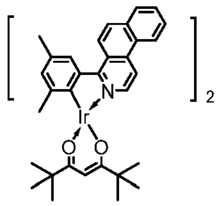

RD16

Examples of the host or assist included in the light emitting layer include, but not limited to, a carbazole derivative, an azine derivative, a xanthone derivative, a dibenzofuran derivative, a dibenzothiophene derivative, an organoaluminum complex such as tris(8-quinolinolato)aluminum, and an organoberyllium complex, in addition to aromatic hydrocarbon compound and derivatives thereof. Specific examples are shown below.

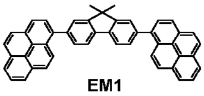

EM1

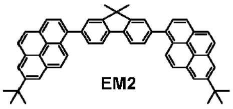

EM2

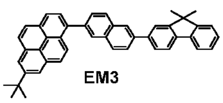

EM3

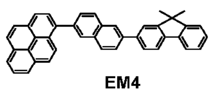

EM4

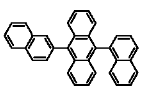

EM5

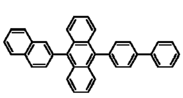

EM6

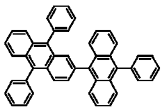

EM7

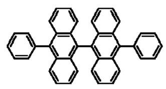

EM8

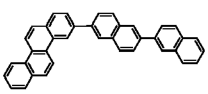

EM9

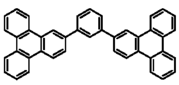

EM10

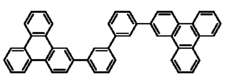

EM11

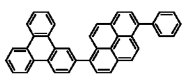

EM12

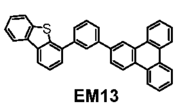

EM13

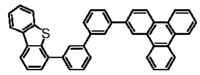
EM14
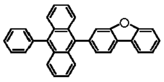
EM15
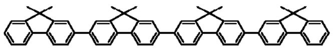
EM16

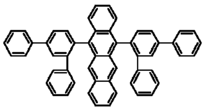
EM17
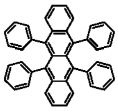
EM18
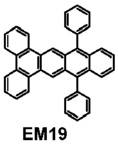
EM19
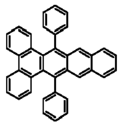
EM20
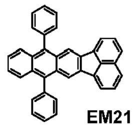
EM21

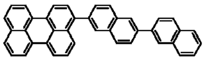
EM22
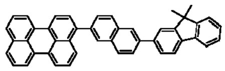
EM23
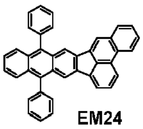
EM24
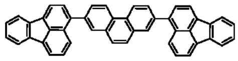
EM25

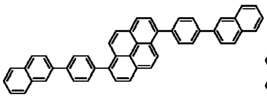
EM26
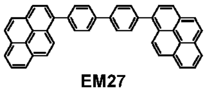
EM27
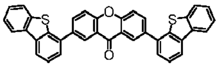
EM28
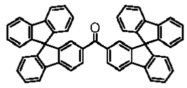
EM29

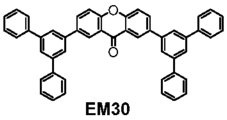
EM30
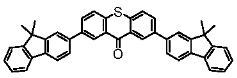
EM31
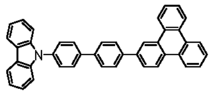
EM32
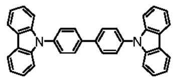
EM33

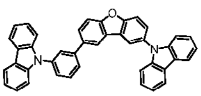
EM34
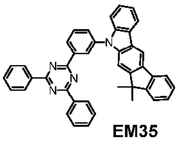
EM35
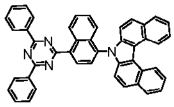
EM36
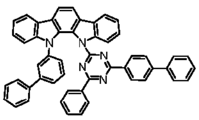
EM37

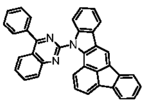
EM38
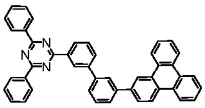
EM39
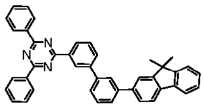
EM40

The electron transport material can be selected arbitrarily from materials that can transport electrons injected from the negative electrode to the light emitting layer and is selected considering the balance with the hole mobility of the hole transporting material and so on. Examples of the material having electron transport performance include an oxadiazole derivative, an oxazole derivative, a pyrazine derivative, a triazole derivative, a triazine derivative, a quinoline derivative, a quinoxaline derivative, a phenanthroline derivative, an organoaluminum complex, and a fused ring compound (e.g., a fluorene derivative, a naphthalene derivative, a chrysene derivative, and an anthracene derivative). Furthermore, the above electron transport material is suitably used also in the hole blocking layer.

Examples of the compound that is used as the electron transport material are shown below, but certainly are not limited thereto.

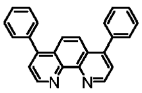
ET1
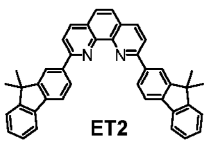
ET2
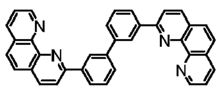
ET3
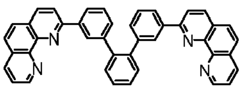
ET4

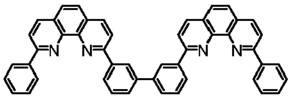 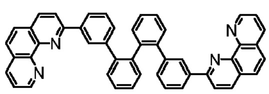 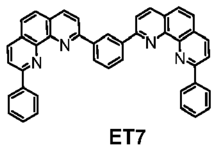

ET5 ET6 ET7

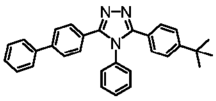 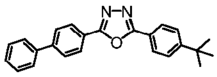 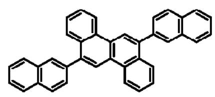 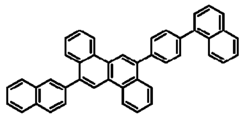

ET8 ET9 ET10 ET11

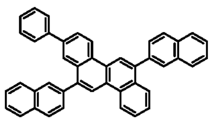 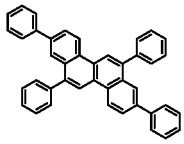 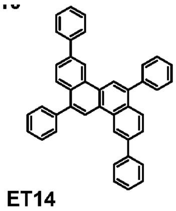 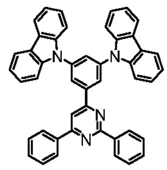

ET12 ET13 ET14 ET15

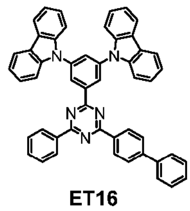 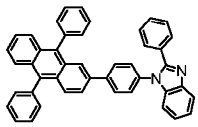 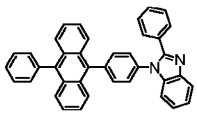 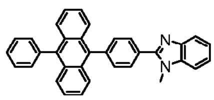

ET16 ET17 ET18 ET19

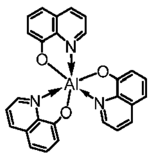 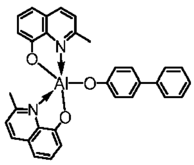 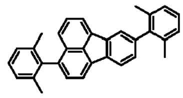 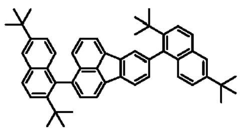

ET20 ET21 ET22 ET23

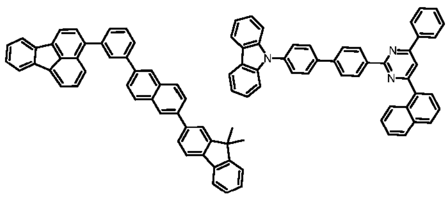 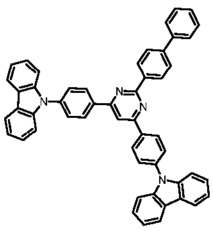 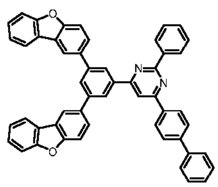

ET24 ET25 ET26 ET27

The electron injection material can be selected arbitrarily from materials that can easily inject electrons from the negative electrode and is selected considering the balance with the hole injection performance and so on. As the organic compounds, an n-type dopant and a reducing dopant are also included, and examples thereof include a compound including an alkali metal such as lithium fluoride, a lithium complex such as lithium quinolinol, a benzimidazolidene derivative, an imidazolidene derivative, a fulvalene derivative, and an acridine derivative. The electron injection material can also be used in combination with the above-mentioned electron transport material. Configuration of organic light emitting element

The organic light emitting element is disposed by forming a first electrode, an organic compound layer, and a second electrode on a substrate. An insulating layer may be disposed on the substrate. On the second electrode, a protection layer, a color filter, a microlens, and so on may be disposed. When a color filter is provided, a planarization layer may be disposed between the color filter and the protection layer. The planarization layer can be made of an acrylic resin or the like. The same applies when a planarization layer is disposed between the color filter and the microlens. One of the first electrode and the second electrode may be a positive electrode, and the other may be a negative electrode.

Substrate

Examples of the substrate include quartz, glass, a silicon wafer, a resin, and a metal. A switching element such as a transistor and wiring may be provided on the substrate, and an insulating layer may be provided thereon. The material of the insulating layer may be any material that can form a contact hole therein such that wiring can be formed between the insulating layer and the first electrode and can secure insulation from wiring not connected. For example, a resin such as polyimide, silicon oxide, or silicon nitride can be used.

Electrode

As the electrode, a pair of electrodes can be used. The pair of electrodes may be a positive electrode and a negative electrode.

When an electric field is applied to a direction in which the organic light emitting element emits light, the electrode at high potential is a positive electrode, and the other is a negative electrode. It is also said that the electrode supplying holes to the light emitting layer is a positive electrode and that the electrode supplying electrons is a negative electrode.

The material constituting the positive electrode can have as large a work function as possible. For example, it is possible to use a simple metal, such as gold, platinum, silver, copper, nickel, palladium, cobalt, selenium, vanadium, and tungsten, a mixture including them, or an alloy by combining them, or a metal oxide such as tin oxide, zinc oxide, indium oxide, indium tin oxide (ITO), and indium zinc oxide. In addition, a conductive polymer such as polyaniline, polypyrrole, and polythiophene can also be used.

These electrode materials may be used alone or in combination of two or more thereof. The positive electrode may be composed of one layer or may be composed of multiple layers.

When the electrode is used as a reflection electrode, for example, chromium, aluminum, silver, titanium, tungsten, molybdenum, an alloy thereof, or a laminate thereof can be used. The above-mentioned materials can also function as a reflection film without having a role as an electrode. When the electrode is used as a transparent electrode, for example, a transparent conductive layer of an oxide, such as indium tin oxide (ITO) and indium zinc oxide, can be used, but it is not limited thereto.

The electrode can be formed by photolithography.

The material constituting the negative electrode can have a small work function, and examples thereof include an alkali metal such as lithium, an alkaline earth metal such as calcium, a simple metal such as aluminum, titanium, manganese, silver, lead, and chromium, and a mixture thereof. An alloy by combining these simple metals can also be used. For example, magnesium-silver, aluminum-lithium, aluminum-magnesium, silver-copper, and zinc-silver can be used. A metal oxide such as indium tin oxide (ITO) can also be used. These electrode materials may be used alone or in combination of two or more. The negative electrode may have a single-layer configuration or may have a multi-layer configuration. In particular, silver can be used, and in order to reduce aggregation of silver, a silver alloy can be used. The ratio of the alloy does not matter as long as the aggregation of silver can be reduced. For example, the ratio of silver : another metal may be, for example, 1 : 1 or 3 : 1.

The negative electrode may be a top emission type element using a conductive layer of an oxide such as ITO or may be a bottom emission element using a reflection electrode of aluminum (Al) or the like and is not particularly limited. Although the formation method of the negative electrode is not particularly limited, a method of DC or AC sputtering may be used because of its good film coverage and an easy reduction in the resistance.

Organic compound layer

The organic compound layer may be formed of a single layer or may be formed of multiple layers. When the organic compound layer includes multiple layers, the layers may be referred to as a hole injection layer, a hole transport layer, an electron blocking layer, a light emitting layer, a hole blocking layer, an electron transport layer, or an electron injection layer, depending on the functions. The organic compound layer is mainly constituted of an organic compound and may include an inorganic atom and an inorganic compound. For example, copper, lithium, magnesium, aluminum, iridium, platinum, molybdenum, or zinc may be included. The organic compound layer may be arranged between the first electrode and the second electrode or may be provided in contact with the first electrode and the second electrode.

The organic compound layers (such as a hole injection layer, a hole transport layer, an electrode blocking layer, a light emitting layer, a hole blocking layer, an electron transport layer, and an electron injection layer) constituting the organic light emitting element according to an embodiment of the present disclosure is formed by the following method.

The organic compound layers constituting the organic light emitting element according to an embodiment of the present disclosure can be formed using a dry process such as vacuum deposition, ionization deposition, sputtering, or plasma. Instead of the dry process, a wet process of dissolving in an appropriate solvent and forming a layer by a known coating method (e.g., spin coating, casting, microgravure coating, gravure coating, bar coating, roll coating, wire bar

coating, dip coating, spray coating, screen printing, flexographic printing, offset printing, inkjet printing, capillary coating, nozzle coating, or an LB method) can also be used. In particular, vacuum deposition, ionization deposition, inkjet printing, and nozzle coating are suitable for manufacturing large-area organic light emitting elements.

Here, when a layer is formed by vacuum deposition, solution coating, or the like, crystallization and so on are less prone to occur, and stability over time is excellent. When a film is formed by a coating method, the film can also be formed in combination with an appropriate binder resin.

Examples of the binder resin include, but not to limited to, a polyvinyl carbazole resin, a polycarbonate resin, a polyester resin, an ABS resin, an acrylic resin, a polyimide resin, a phenol resin, an epoxy resin, a silicon resin, and a urea resin.

These binder resins may be used alone as a homopolymer or a copolymer or may be used as a mixture of two or more. Furthermore, as needed, a known additive such as a plasticizer, an oxidation inhibitor, and an ultraviolet absorber may be used in combination.

The thickness of each layer in the organic light emitting element is usually 1 nm or more and 10 μm or less. In particular, the film thickness of the light emitting layer of the organic compound layer can be 10 nm or more and 100 nm or less for obtaining effective luminescence properties.

Charge generation layer

The charge generation layer is formed when an n/p junction is formed with a player and an n-layer or is formed using a p-doped layer and an n-doped layer. For example, when the layer is formed with a P/N junction only, the electron injection layer may be disposed such that electrons extracted into the P layer are further injected into the electron transport layer. The charge generation layer may be n-doped layer/p-doped layer. The present disclosure is not limited by any combination as the charge generation layer.

The p-doped layer may include, for example, a mixture of highly electron attractive HAT-CN or Lewis acid such as molybdenum oxide and an aromatic amine compound. HAT-CN and molybdenum trioxide are n-type materials, which means that electrons may be extracted to form a lamination configuration. An np-junction composed of lamination of a p-doped layer or n-type material and a p-type material is treated as a p-charge generation layer.

The n-doped layer can be, for example, a layer with a low work function to be easily electron-doped, such as an alkali metal and an alkaline earth metal. In the present disclosure, the n-doped layer is treated as an n-charge generation layer. Alternatively, an electron injection layer may be formed by combining LiF or the like with a reducible metal thin film to form, and an n-type layer/p-type layer may be formed to generate charge.

As the n dopant, for example, an alkali metal such as Li, Na, K, Rb, and Cs, an alkaline earth metal such as Mg, Ca, Sr, and Ba, a rare earth metal such as Yb, and compounds thereof (alkali metal compounds (including an oxide such as lithium oxide, a halide, and a carbonate such at lithium carbonate and cesium carbonate), alkaline earth metal compounds (including an oxide, a halide, and a carbonate), and rare earth metal compounds (including an oxide, a halide, and a carbonate)) can be used.

Protection layer

A protection layer may be disposed on the second electrode. For example, infiltration of water or the like into the organic compound layer is reduced by bonding glass provided with a moisture absorbent on the second electrode, and thereby occurrence of a display defect can be reduced. In another embodiment, infiltration of water or the like into the organic compound layer may be reduced by disposing a passivation film of silicon nitride or the like on the second electrode. For example, a second electrode is formed and is then conveyed to another chamber without breaking the vacuum, and a silicon nitride film with a thickness of 2 μm may be formed by a CVD method as a protection layer. After the film formation by a CVD method, a protection layer may be disposed using an atomic layer deposition method (ALD method). The material of the film to be formed by the ALD method is not limited, but may be silicon nitride, silicon oxide, aluminum oxide, or the like. Silicon nitride may be further formed by a CVD method on the film formed by an ALD method. The film thickness of the film formed by the ALD method may be smaller than that of the film formed by the CVD method. Specifically, it may be 50% or less or 10% or less.

Color filter

A color filter may be disposed on the protection layer. For example, a color filter may be disposed on another substrate considering the size of the organic light emitting element and may be pasted to the substrate provided with the organic light emitting element. The color filter may be patterned on the above-described protection layer using photography technology. The color filter may be constituted of a polymer. Planarization layer

A planarization layer may be provided between the color filter and the protection layer. The planarization layer is

disposed for the purpose of reducing the unevenness of the under layer. The planarization layer may be called as a material resin layer without limiting the purpose. The planarization layer may be constituted of an organic compound which may be low molecular or high molecular and can be high molecular.

Planarization layers may be disposed on and under the color filter, and the materials constituting them may be the same or different. Specifically, examples thereof include a polyvinyl carbazole resin, a polycarbonate resin, a polyester resin, an ABS resin, an acrylic resin, a polyimide resin, a phenol resin, an epoxy resin, a silicon resin, and a urea resin.

Microlens

The organic light emitting element may include an optical member such as a microlens on its light emission side. The microlens can be constituted of an acrylic resin, an epoxy resin, or the like. The purpose of the microlens may be an increase in the amount of light to be extracted from the organic light emitting element and control of the direction of light to be extracted. The microlens may have a hemispherical shape. When the microlens has a hemispherical shape, in tangential lines that are in contact with the hemisphere, there is a tangential line that is parallel to the insulating layer, and the contact point between the tangential line and the hemisphere is the vertex of the microlens. The vertex of the microlens can be determined similarly in an arbitrary cross-sectional view. That is, there is a tangential line that is parallel to the insulating layer in the tangential lines that are in contact with the semicircle of the microlens in the cross-sectional view, and the contact point between the tangential line and the semicircle is the vertex of the microlens.

The middle point of the microlens can also be defined. In a cross section of a microlens, a line segment from the point where the shape of an arc ends to the point where the shape of another arc ends is assumed, and the middle point of the line segment can be called the middle point of the microlens. The cross section that distinguish between the vertex and the middle point may be a cross section perpendicular to the insulating layer.

Opposite substrate

An opposite substrate may be disposed on the planarization layer. The opposite substrate is called as so because it is disposed at a position corresponding to the above-described substrate. The material constituting the opposite substrate may be the same as the above-described substrate. When the above-described substrate is defined as a first substrate, the opposite substrate may be a second substrate.

Specific example of exposure head

Fig. 5 is a schematic view showing one aspect of a light emission device that can be used in the exposure head of the present embodiment. The light emission device of the present embodiment can be used as a light source of an image-forming apparatus. The light emission device of the present embodiment has a rectangular shape having long sides parallel to a first direction and short sides crossing the first direction. For example, the first direction may be a direction along the rotation axis direction of the photoreceptor of an image-forming apparatus.

The substrate 1701 has a polygonal shape, and a rectangular substrate 1701 will be described here as an example. In the present specification, the long side direction of the rectangular substrate 1701 is referred to as a first direction, and the short side direction orthogonal to the long side direction is referred to a second direction. The polygon of the present specification includes a shape with rounded corners. A moisture resistant ring 1700 that plays a role of reducing and preventing infiltration of water into the inside of the light emission device is arranged on the rectangular substrate 1701. The moisture resistant ring 1700 can be, for example, a guard ring constituted of a wiring layer.

An emission region 1702, a contact region 1703, a pad 1704, and a circuit 1706 are arranged inside the moisture resistant ring 1700. In the present embodiment, the contact region 1703 includes a first contact region 1703_1, a second contact region 1703_2, a third contact region 1703_3, a fourth contact region 1703_4, and a fifth contact region 1703_5. The pad 1704 includes a first pad 1704_1, a second pad 1704_2, and a third pad 1704_3.

The circuit 1706 is a circuit that is a part of circuits respectively driving the light emission device, and includes a circuit 1706_1 and a circuit 1706_2. Examples of the circuits 1706_1 and 1706_2 include, but not limited to, an input protection circuit, an input circuit into which data for each driving are input, and a logic circuit for processing data.

In the emission region 1702, light emitting elements EL are arranged in a matrix direction. The contact region 1703 is a region where wiring that is electrically connected to a common electrode of the light emitting elements EL is arranged. The pad 1704_1 electrically connects the contact region 1703 to an external element.

The periphery shape of the moisture resistant ring 1700 may include multiple recessed portions (recess portion 1705). This portion can be used as, for example, an abut region for abutting a rib that is a part of mask for deposition in a film forming step.

Each of the multiple light emitting elements EL arranged in a matrix in the emission region 1702 is constituted of, as described above, a light emitting layer and a first electrode and a second electrode sandwiching the light emitting layer.

The present embodiment shows an example in which the first electrode is an independent electrode provided to each of the light emitting elements EL, and the second electrode is a common electrode provided in common to the light emitting elements EL.

For example, when the light emitting elements EL are arranged in four rows in the emission region 1702, as shown in Fig. 5, the initial position of the light emitting elements EL in the first row may be shifted from the initial position of the light emitting elements EL in the second row in the X direction (first direction) by 1/4 of the dimension of the light emitting element EL in the X direction. When n rows are arranged, where n is an integer of 2 or more, the initial position of the light emitting elements EL in the first row may be shifted from the initial position of the light emitting elements EL in the second row in the X direction by 1/n of the dimension of the light emitting element EL in the X direction.

Such a configuration is advantageous for improving the resolution.

The contact region 1703 is an adjacent region of the emission region 1702 of the substrate 1701 and is arranged inside the moisture resistant ring 1700. At least one of the contact region 1703, the pad 1704, and the circuit 1706 may arranged between the emission region 1702 and one long side end portion of the substrate 1701 together with the recess portion 1705 of the moisture resistant ring 1700 and arranged in series in the long side direction.

Thus, the length of the light emission device in the short side direction is reduced by disposing the contact region 1703, the pad 1704, the circuit 1706, and so on at positions in the same short side direction, and the light emission device can thereby be reduced in size.

The light emission device of this exemplary example include multiple contact regions 1703 of the common electrode of the light emitting element EL with the power source wiring along the long side end of the light emission device. When the common electrode is, for example, constituted of a transparent electrode material having a relatively high electric resistance, in the long side direction, the amount of voltage drop may be increased. Accordingly, the voltage applied to each light emitting element EL varies depending on the distance from the contact region 1703 to which the voltage is supplied. Consequently, actual luminance differs between the light emitting elements EL applied with voltage for emitting light with the same luminance, and shading or the like may occur. As in the present embodiment, the voltage drop of the common electrode in the long side direction is decreased by disposing multiple contact regions 1703 in the long side direction, and occurrence of shading and so on can be reduced.

In the present embodiment, an example of using a light emission device in a head substrate 1800 of an exposure head of an image-forming apparatus will be described using Figs. 6A to 6C. Fig. 6A is a schematic perspective view of the head substrate 1800. Fig. 6B shows an arrangement of multiple light emitting elements EL disposed on the head substrate 1800, and Fig. 6C is an enlarged view of a part of Fig. 6B.

An LED chip 1803 is mounted on the head substrate 1800. As the LED chip 1803, for example, the light emission device shown in Fig. 5 can be used.

As shown in Fig. 6A, the LED chip 1803 is disposed on one surface of the head substrate 1800, and a long-length flexible flat cable (FFC) connector 1807 is disposed on the other surface. Here, one surface of the head substrate 1800 is the face (top face, front face) on the side where the LED chip 1803 is disposed. The other surface of the head substrate 1800 is the face (bottom face, rear face) opposite to the side where the LED chip 1803 is disposed.

The FFC connector 1807 is attached to the other face (bottom face, rear face) of the head substrate 1800 such that the longitudinal direction thereof is along the longitudinal direction of the head substrate 1800. The long-length FFC connector 1807 is provided so that control signals (driving signals) are input from the control circuit portion of the image-forming apparatus main body, and the control signals are transferred to each LED chip 1803.

The LED chip 1803 is driven (light emission or extinction operation) by the control signal input into the head substrate 1800.

The LED chip 1803 mounted on the head substrate 1800 will be described. As shown in Figs. 6B and 6C, multiple LED chips 1803 are arranged on one surface of the head substrate 1800. For example, LED chip 1803_1 to 1803_29 (29 chips) are disposed. In Fig. 6B, LED chips 1803_1, 1803_13, 1803_14, 1803_15, 1803_16, and 1803_29 are exemplified. Multiple light emitting elements EL, for example, 516 light emitting elements EL, are disposed on each of the LED chips 1803_1 to 1803_29 in its longitudinal direction.

In the longitudinal direction of the LED chip 1803, the distance k2 between the centers of adjacent light emitting elements EL corresponds to the resolution of the image-forming apparatus. For example, when the resolution of the image-forming apparatus of this exemplary example is defined as 1200 dpi, the light emitting elements EL are disposed in the longitudinal direction of the LED chips 1803_1 to 1803_29 such that the distance k2 between the centers of adjacent light emitting elements EL is 21.16 μm. Accordingly, the exposure range of the exposure head of this exemplary example is about 314 mm.

The photosensitive layer of the photosensitive drum is formed with a width of 314 mm or more. Since the length of the long side of A4 size recording paper and the length of the short side of A3 size recording paper are 297 mm, the exposure head of the present embodiment has an exposure range capable of forming images on A4 size recording paper and A3 size recording paper. Although Fig. 6B shows an example in which multiple light emitting elements EL are disposed in the longitudinal direction, light emitting elements EL may be disposed in the short-side direction in addition to the

longitudinal direction.

The LED chips 1803_1 to 1803_29 are disposed in multiple columns in the axial direction of the photosensitive drum. Specifically, the LED chips 1803_1 to 1803_29 are arranged alternately in two columns along axial direction of the photosensitive drum. That is, as shown in Fig. 6B, odd-numbered LED chips 1803_1, 1803_3, ..., and 1803_29 counted from the left side are mounted on the head substrate 1800 in one line in the longitudinal direction. In addition, even-numbered LED chips 1803_2, 1803_4, ..., and 1803_28 counted from the left side are mounted on the head substrate 1800 in one line in the longitudinal direction. The LED chips 1803 are arranged in such a manner.

Consequently, as shown in Fig. 6C, in the longitudinal direction of the LED chip 1803, the distance k1 between the centers of light emitting elements EL and the distance k2 between the centers of the light emitting elements EL can be equal to each other. Here, the distance k1 between the centers of the light emitting elements EL indicates the distance between the centers of light emitting elements EL disposed at one end of the LED chip 1803_13 and the other end of the LED chip 1803_14. The distance k2 between the centers of the light emitting elements EL indicates the distance k2 between the centers of adjacent light emitting elements EL in the LED chip 1803_14. That is, the distance k1 between centers of adjacent light emitting elements EL disposed at one end of one LED chip 1803 and at the other end of the other LED chip 1803 can be the same as the distance k2 between the centers of adjacent light emitting elements EL on one LED chip 1803.

In the present embodiment, the light emitting element EL is an organic light emitting element and is a current-driven light emitting element. The organic light emitting elements are arranged, for example, on a TFT (thin film transistor) substrate in a line along the main scanning direction (the axial direction of the photosensitive drum) and are electrically connected in parallel by power source wiring disposed along the same main scanning direction.

When the light emission device is used in an exposure head, linear exposure is performed. Accordingly, the shape of the emission region 1702 has a ratio of the longitudinal direction (first direction X) to the short-side direction (second direction Y) larger than that when the light emission device is used in a display or the like. The shape of the substrate of the LED chip also has a large ratio of the longitudinal direction (first direction X) to the short-side direction (second direction Y). Specifically, for example, the length of the long side of the LED chip 1803 (or the emission region 1702) is 5 times or more or may be 10 times or more the length of the short side of the LED chip 1803 (or the emission region 1702). For example, the length of the long side of the LED chip 1803 (or the emission region 1702) can be 20 times or more the length of the short side of the LED chip 1803 (or the emission region 1702).

The length of the long side of the LED chip 1803 is determined depending on the length of the photosensitive drum in the axial direction, the number of the LED chips arranged in the axial direction, and the manner of arrangement of the LED chips 1803. The length of the short side of the LED chip 1803 is determined by whether light emitting elements EL are arranged in the emission region 1702 in the direction perpendicular to the axis of the photosensitive drum or by the arrangements of the pads 1704 and the contact regions 1703.

The organic compound layer of the light emitting element EL can be configured so as to have a light emitting layer that emits red light considering the wavelength dependence of the photosensitivity of the photosensitive drum.

The LED chip 1803 may have a color filter. An LED chip having a color filter can absorb stray light from unintended directions without decreasing the regular amount of light entering the photosensitive drum and can therefore improve the print quality.

## Photoreceptor

Fig. 7 shows one example of the layer configuration of the photoreceptor of the present disclosure. In Fig. 7, an underlying layer 122, a charge generation layer 123, a charge transport layer 124, and a protection layer 125 are laminated on a supporting member 121. The photosensitive layer may be configured as a lamination type photosensitive layer including a charge generation layer 123 and a charge transport layer 124 as shown in Fig. 7 or may be configured as a single-layer type photosensitive layer containing a charge-generating material and a charge-transporting material.

Examples of the method for manufacturing the photoreceptor of the present disclosure include a method in which application liquids for respective layers described later are prepared, and desired layers are applied in turns and dried. On this occasion, examples of the application method of the application liquid include dip coating, spray coating, ink-jet coating, roll coating, die coating, blade coating, curtain coating, wire bar coating, and ring coating. Among these methods, from the viewpoint of efficiency and productivity, dip coating can be used.

A configuration of the photoreceptor of the present disclosure will now be described.

### Supporting member 121

The supporting member 121 of the photoreceptor can be a conductive substance (conductive supporting member).

The supporting member of the present disclosure has a drum-like (cylindrical) shape. The surface of the

supporting member may be subjected to electrochemical treatment such as anodic oxidation, blast treatment, or cutting treatment.

The material of the supporting member 121 can be a metal, a resin, glass, or the like. Examples of the metal include aluminum, iron, nickel, copper, gold, stainless steel, and alloys thereof. In particular, an aluminum supporting member may be used. The resin and glass can be provided with conductivity by treatment such as mixing or coating with a conductive material.

Underlying layer 122

In the present disclosure, an underlying layer 122 may be disposed on the supporting member 121. The underlying layer 122 is provided for the purpose of improvement in the adhesiveness of the photosensitive layer, improvement in coatability, improvement of charge injection from the supporting member 121, protection of the photosensitive layer from electrical breakdown, a reduction of interference fringes by scattering of image exposure light, and so on. The underlying layer 122 may be composed of one underlying layer containing the material shown below or may be disposed by laminating two or more different underlying layers containing the materials shown below.

Examples of the metal oxide particle include particles of indium tin oxide, tin oxide, indium oxide, titanium oxide, strontium titanate, zinc oxide, and aluminum oxide. A particle of silicon dioxide can also be used. Examples of the metal particle include particles of gold, silver, and aluminum. The particle diameter of the primary particle of the metal oxide particle can be 0.1 μm or less as the number average particle size from the viewpoint of the dispersibility of the application liquid for the underlying layer and electrical properties of the photoreceptor. In the present disclosure, the metal oxide particle may be a mixture of two or more different types of metal oxides, different types of surface treatment, or particles with different particle diameters or specific surface areas.

The metal oxide particle contained in the underlying layer 122 may be a particle with a surface treated with a surface treatment agent such as a silane coupling agent in order to reduce black dot image defects due to charge injection from the supporting member 121 to the photosensitive layer side. As the method for treating the surface of the metal oxide particle, a general method is used, and examples thereof include a dry method and a wet method.

In the dry method, while stirring a metal oxide particle in a high-speed mixing mixer such as a Henschel mixer, an alcohol aqueous solution, organic solvent solution, or aqueous solution containing a surface treatment agent is added thereto, and after uniform dispersion, drying is performed.

In the wet method, a metal oxide particle and a surface treatment agent are stirred in a solvent or are dispersed with, for example, a sand mill using glass beads or the like, and after dispersion, the solvent is removed by filtration or distillation under reduced pressure. After removal of the solvent, baking at 100°C or higher may be further performed.

The underlying layer 122 can contain a resin. The underlying layer may be formed as a cured film by polymerizing a composition containing a monomer having a polymerizable functional group.

Examples of the resin include an acrylic resin, an allyl resin, an alkyd resin, an ethyl cellulose resin, an ethylene-acrylic acid copolymer, an epoxy resin, a casein resin, and a silicone resin. The examples also include a gelatin resin, a phenol resin, a urethane resin, a butyral resin, a polyacrylate resin, a polyacetal resin, a polyamide-imide resin, a polyamide resin, a polyallyl ether, a polyimide resin, a polyester resin, and a polyethylene resin.

The examples also include a polycarbonate resin, a polystyrene resin, a polysulfone resin, a polyvinyl alcohol resin, a polybutadiene resin, and a polypropylene resin. Among these resins, from the viewpoint of reducing the potential fluctuation under high temperature and high humidity environment, a urethane resin, which has low hygroscopic properties, can be used.

Examples of the polymerizable functional group include an isocyanate group, a blocked isocyanate group, a methylol group, an alkylated methylol group, an epoxy group, a metal alkoxide group, a hydroxy group, an amino group, a carboxy group, a thiol group, a carboxylic acid anhydride group, and a carbon-carbon double bond group.

The mass ratio of the metal oxide particle (P) to the binding resin (B), (P/B), in the underlying layer 122 can be 1.0/1.0 or more and 3.0/1.0 or less.

The underlying layer 122 may further contain an electron-transporting material, a metal particle, a conductive polymer, or the like for the purpose of enhancing the electrical properties. Among them, the electron-transporting material may be used.

Examples of the electron-transporting material include a quinone compound, an imide compound, a benzimidazole compound, a cyclopentadienylidene compound, a fluorenone compound, an oxadiazole compound, a diphenoquinone compound, a xanthone compound, an alizarin compound, a benzophenone compound, a cyanovinyl compound, a halogenated aryl compound, a silole compound, and a boron-containing compound.

The underlying layer may be formed as a cured film by using an electron-transporting material having a polymerizable functional group as an electron-transporting material and copolymerizing with a monomer having the above-described polymerizable functional group.

The underlying layer 122 may further contain, for example, an organic resin particle or a leveling agent for the

purpose of adjusting the surface roughness, enhancing light scattering, or reducing cracking. As the organic resin particle, a hydrophobic organic resin particle such as a silicone particle and a hydrophilic organic resin particle such as a crosslinked polymethacrylate resin (PMMA) particle can be used.

The underlying layer 122 may further contain an additive, for example, a known material such as a conductive material particle such as carbon black, a charge-transporting material, a metal chelate compound, and an organic metal compound.

The underlying layer 122 can be formed by preparing application liquid for an underlying layer containing each of the above-described materials and solvent, forming a coating film of the liquid on a supporting member 121 or a conductive layer, and drying and/or curing the film. Examples of the solvent used in the application liquid for an underlying layer include organic solvents such as an alcohol, a sulfoxide, a ketone, an ether, an ester, an aliphatic halogenated hydrocarbon, and an aromatic compound. In the present disclosure, an alcohol or ketone solvent may be used. Examples of the dispersion method for preparing the application liquid for an underlying layer include methods using a homogenizer, an ultrasonic disperser, a ball mill, a sand mill, a roll mill, a vibration mill, an attritor, or a liquid-collision high-speed disperser.

The film thickness of the underlying layer 122 is preferably 0.1 μm or more, more preferably 0.2 μm or more, and particularly preferably 0.3 μm or more. In addition, the film thickness of the underlying layer 122 is preferably 50 μm or less, more preferably 40 μm or less, and more preferably 30 μm or less.

Photosensitive layer

The photosensitive layer of the photoreceptor is mainly classified into (1) a lamination type photosensitive layer and (2) a single-layer type photosensitive layer. (1) The lamination type photosensitive layer is a photosensitive layer including a charge generation layer 123 containing a charge-generating material and a charge transport layer 124 containing a charge-transporting material. (2) The single-layer type photosensitive layer is a photosensitive layer containing both a charge-generating material and a charge-transporting material.

(1) Lamination type photosensitive layer

The lamination type photosensitive layer includes a charge generation layer 123 and a charge transport layer 124.

(1-1) Charge generation layer 123

The charge generation layer 123 can contain a charge-generating material and a resin.

Examples of the charge-generating material include an azo pigment, a perylene pigment, a polycyclic quinone pigment, an indigo pigment, and a phthalocyanine pigment. Among these pigments, an azo pigment and a phthalocyanine pigment may be used. As the phthalocyanine pigment, an oxytitanium phthalocyanine pigment, a chlorogallium phthalocyanine pigment, and a hydroxygallium phthalocyanine pigment can be used.

The content of the charge-generating material in the charge generation layer 123 is preferably 40 mass% or more and 85 mass% or less and more preferably 60 mass% or more and 80 mass% or less based on the total mass of the charge generation layer 123.

Examples of the resin include a polyester resin, a polycarbonate resin, a polyvinyl acetal resin, a polyvinyl butyral resin, an acrylic resin, a silicone resin, an epoxy resin, a melamine resin, a polyurethane resin, a phenol resin, a polyvinyl alcohol resin, a cellulose resin, a polystyrene resin, a polyvinyl acetate resin, and a polyvinyl chloride resin. Among these resins, a polyvinyl butyral resin may be used.

The charge generation layer 123 may further contain an additive such as an oxidation inhibitor and an ultraviolet absorber. Specifically, examples of the additive include a hindered phenol compound, a hindered amine compound, a sulfur compound, a phosphorus compound, and a benzophenone compound.

The charge generation layer 123 can be formed by preparing application liquid for a charge generation layer containing each of the above-described materials and solvent, forming a coating film of the liquid on the underlying layer 122, and drying the film. Examples of the solvent used in the application liquid include an alcohol solvent, a sulfoxide solvent, a ketone solvent, an ether solvent, an ester solvent, and an aromatic hydrocarbon solvent.

The film thickness of the charge generation layer 123 is preferably 0.1 μm or more and 1 μm or less and more preferably 0.15 μm or more and 0.4 μm or less.

(1-2) Charge transport layer 124

The charge transport layer 124 can contain a charge-transporting material and a binder material. When a protection layer 125 described later is not provided, the charge transport layer 124 functions as the surface layer of the

photoreceptor.

Examples of the charge-transporting material include a polycyclic aromatic compound, a heterocyclic compound, a hydrazone compound, a styryl compound, an enamine compound, a triarylamine compound, and resins having groups derived from these substances. Among these materials, a triarylamine compound may be used.

The content of the charge-transporting material in the charge transport layer 124 is preferably 25 mass% or more and 70 mass% or less and more preferably 30 mass% or more and 55 mass% or less based on the total mass of the charge transport layer.

As the binder material, a thermoplastic resin (hereinafter, also referred to as "resin") is used. Examples of the thermoplastic resin include a polyester resin, a polycarbonate resin, an acrylic resin, and a polystyrene resin. Among these resins, a polycarbonate resin or a polyester resin may be used. The polyester resin can be a polyacrylate resin.

The content ratio (mass ratio) of the charge-transporting material and the resin is preferably 4 : 10 to 20 : 10 and more preferably 5 : 10 to 12 : 10.

The charge transport layer 124 may contain an additive such as an oxidation inhibitor, an ultraviolet absorber, a plasticizer, and a leveling agent. Specifically, examples of the additive include a hindered phenol compound, a hindered amine compound, a sulfur compound, a phosphorus compound, a benzophenone compound, a siloxane-modified resin, silicone oil, a polystyrene resin particle, a polyethylene resin particle, and a boron nitride particle.

The charge transport layer 124 can be formed by preparing application liquid for a charge transport layer containing each of the above-described materials and solvent, forming a coating film of the liquid on the charge generation layer 123, and drying the film. Examples of the solvent used in the application liquid include an alcohol solvent, a ketone solvent, an ether solvent, an ester solvent, and an aromatic hydrocarbon solvent. In these solvents, an ether solvent or an aromatic hydrocarbon solvent may be used.

The film thickness of the charge transport layer 124 is preferably 5 μm or more and 50 μm or less, more preferably 8 μm or more and 40 μm or less, and particularly preferably 10 μm or more and 30 μm or less.

(2) Single-layer type photosensitive layer

The single-layer type photosensitive layer can be formed by preparing application liquid for a photosensitive layer containing a charge-generating material, a charge-transporting material, a resin, and a solvent, forming a coating film of the liquid on the underlying layer 122, and drying the film. Examples of the charge-generating material, charge-transporting material, and resin are the same as the materials exemplified in the above "(1) Lamination type photosensitive layer".

Protection layer 125

In the present disclosure, a protection layer 125 may be disposed on the photosensitive layer. It is possible to enhance the durability by disposing the protection layer 125. When the protection layer 125 is disposed, the protection layer 125 functions as the surface layer of the photoreceptor.

The protection layer 125 may be formed as a cured film by polymerizing a composition containing a raw material of the binder material, for example, a monomer having a polymerizable functional group. Examples of the reaction in this case include a thermal polymerization reaction, an optical polymerization reaction, and a radiation polymerization reaction. Examples of the polymerizable functional group of the monomer having a polymerizable functional group include an isocyanate group, a blocked isocyanate group, a methylol group, an alkylated methylol group, an epoxy group, a metal alkoxyl group, a hydroxy group, an amino group, a carboxy group, a thiol group, a carboxylic acid anhydride group, and a group containing a carbon-carbon double bond. Examples of the group containing a carbon-carbon double bond include an acryloyl group and a methacryloyl group. The monomer having a polymerizable functional group may be a monomer having charge transport ability. Here, the cured product of a monomer having a polymerizable functional group is a binder material for the protection layer 125.

As the monomer having a polymerizable functional group, a hole transport compound having a chain-polymerizable functional group can be used. The hole transport compound having a chain-polymerizable functional group can be a compound represented by the following formula (CT-1) or (CT-2):

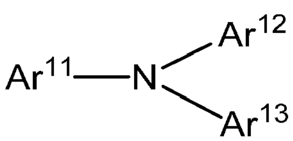

(CT-1)

In the formula (CT-1), $Ar^{11}$ to $Ar^{13}$ each independently represent a substituted or unsubstituted aryl group. The substituent that the substituted aryl group may have is an alkyl group having 1 or more and 6 or less carbon atoms or a

monovalent functional group represented by any of the following formulae (P-1) to (P-3). However, the compound represented by the formula (CT-1) includes at least one monovalent functional group represented by any of the following formulae (P-1) to (P-3).

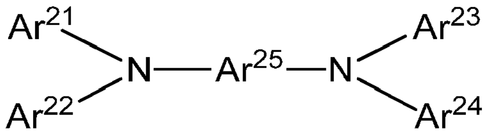

(CT-2)

In the formula (CT-2), $Ar^{21}$ and $Ar^{24}$ each independently represent a substituted or unsubstituted aryl group, and $Ar^{25}$ represents a substituted or unsubstituted arylene group. The substituent that the substituted aryl group may have is an alkyl group having 1 or more and 6 or less carbon atoms or a monovalent functional group represented by any of the following formulae (P-1) to (P-3). The substituent that the substituted arylene group may have is an alkyl group having 1 or more and 6 or less carbon atoms or a monovalent functional group represented by any of the following formulae (P-1) to (P-3). However, the compound represented by the formulae (CT-2) includes at least one monovalent functional group represented by any of the following formulae (P-1) to (P-3).

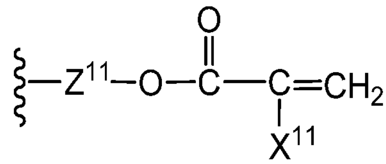

(P-1)

In the formula (P-1), $Z^{11}$ represents a single bond or an alkylene group having 1 or more and 6 or less carbon atoms, and $X^{11}$ represents a hydrogen atom or a methyl group.

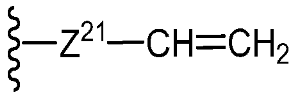

(P-2)

In the formula (P-2), $Z^{21}$ represents a single bond or an alkylene group having 1 or more and 6 or less carbon atoms.

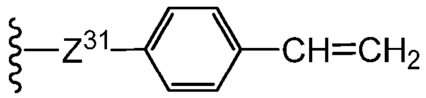

(P-3)

In the formula (P-3), $Z^{31}$ represents a single bond or an alkylene group having 1 or more and 6 or less carbon atoms.

The protection layer 125 may contain a fluorine atom-containing resin particle. It is possible to enhance the abrasion resistance of the protection layer by containing the fluorine atom-containing resin particle.

Examples of the resin contained in the fluorine atom-containing resin particle include a polytetrafluoroethylene resin, a polychlorotrifluoroethylene resin, a polytetrafluoroethylene propylene resin, a polyvinyl fluoride resin, a polyvinylidene fluoride resin, and a polydichlorodifluoroethylene resin. A particle containing multiple of these resins may be used. In particular, from the viewpoint of improving the dispersibility, the fluorine atom-containing resin particle can be a polytetrafluoroethylene (PTFE) resin.

In cross-sectional observation of the protection layer 125, the fluorine atom-containing resin particle can have an average primary particle diameter of 150 nm or more and 300 nm or less, the average primary particle diameter being an arithmetic average of the long diameters of primary particles measured from a secondary electron image by a scanning electron microscope, from the viewpoint of improving the dispersibility and reducing the potential fluctuation. Furthermore, the fluorine atom-containing resin particle can have an average primary particle diameter of 180 nm or more and 250 nm or less.

The content of the fluorine atom-containing resin particle in the protection layer 125 is preferably 5 mass% or more and 40 mass% or less and more preferably 25 mass% or more and 35 mass% or less based on the total mass of the protection layer.

The protection layer 125 may contain an additive such as an oxidation inhibitor, an ultraviolet absorber, a plasticizer, and a leveling agent. Specifically, examples of the additive include a hindered phenol compound, a hindered

amine compound, a sulfur compound, a phosphorus compound, a benzophenone compound, a siloxane-modified resin, silicone oil, a polystyrene resin particle, a polyethylene resin particle, and a boron nitride particle.

The protection layer 125 can be formed by preparing application liquid for a protection layer containing each of the above-described materials and solvent, forming a coating film of the liquid on the photosensitive layer, and drying and/or curing the film. Examples of the solvent used in the application liquid include an alcohol solvent, a ketone solvent, an ether solvent, a sulfoxide solvent, an ester solvent, and an aromatic hydrocarbon solvent.

The film thickness of the protection layer 125 is preferably 0.50 μm or more and 10 μm or less and more preferably 1 μm or more and 7 μm or less.

Surface processing of photoreceptor

In the present disclosure, the surface of the photoreceptor may be processed. It is possible to more stabilize the behavior of the cleaning means (cleaning blade) that is brought into contact with the photoreceptor by performing the surface processing. Examples of the method of the surface processing include a method of pressing a mold having convex portions against the surface of the photoreceptor to perform shape transfer, a method of providing a concave-convex shape by mechanical grinding, and a method of allowing particles to collide with the surface of the photoreceptor to roughen the surface. Thus, the behavior of the cleaning means that is brought into contact with the photoreceptor can be more stabilized by providing recess portions or convex portions to the surface layer of the photoreceptor.

The recess portion or the convex portion may be formed on the entire surface of the photoreceptor or may be formed on part of the surface of the photoreceptor. When the recess portion or the convex portion is formed on part of the surface of the photoreceptor, the recess portion or the convex portion can be formed in at least the entire region in contact with the cleaning means (cleaning blade). When a recess portion is formed, the recess portion can be formed on the surface of the photoreceptor by pressing a mold having a convex portion corresponding to the recess portion to the surface of the photoreceptor to transfer the shape.

EXAMPLES

Example 1

Organic light emitting element

In this example, an organic EL element shown in Fig. 3 was produced. Specifically, a top emission type laminated organic EL element in which a positive electrode (reflection electrode) 2, a hole injection layer 3, a hole transport layer 4, a light emitting layer 5, a first electron transport layer 6, a second electron transport layer 7, an electron injection layer 8, a negative electrode (light extraction electrode) 9, a first protection layer 10, a second protection layer 11, and a third protection layer 12 are sequentially formed on a substrate 1 was produced. The light emitting layer 5 was formed from a red light emitting material and a host material.

A titanium (Ti) film of 40 nm was formed by sputtering as a positive electrode 2 on the substrate 1 laminated with a wiring layer on a silicon substrate and patterned using photolithography technology to form an array of Ti pixels having a square pixel aperture and wiring. The pixel aperture was 20 μm on a side.

Subsequently, a vacuum deposition apparatus was attached with a silicon substrate washed with UV/ozone and materials and exhausted to $1.0 \times 10^{-4}$ Pa ($1 \times 10^{-6}$ Torr). Subsequently, the thicknesses of the hole injection layer 3 and hole transport layer 4 were adjusted to film thicknesses giving an interference structure that enhances the emission wavelength. Then, a light emitting layer 5 containing a red light emitting material was formed. Then, a first electron transport layer 6, a second electron transport layer 7, and an electron injection layer 8 were formed in this order with thicknesses giving an interference structure that enhances the emission wavelength. Subsequently, a negative electrode 9 was formed. Furthermore, sequentially, a silicon oxide film was formed by a CVD method as a first protection layer 10, an aluminum oxide film was formed by an ALD method as a second protection layer 11, and a silicon oxide film was formed by a CVD method as a third protection layer 12. Thus, an organic light emitting element was produced. It was confirmed that the emission spectrum of this organic light emitting element was intense light having multiple peaks with wide wavelength range of 500 nm to 800 nm.

Exposure head and image-forming apparatus

The organic light emitting element (OLED) chip produced on the silicon substrate was cut, and 17 chips were attached on a PCB substrate. This PCB substrate loaded with the OLED chips was provided and installed in a housing attached with a lens array to produce an exposure head. Image evaluation was performed using a copier incorporating this exposure head, and as a result, evaluation images could be stably output, and it was confirmed visually that image defects

were reduced. Consequently, it was judged that the effects of the present disclosure were apparent.

As shown in Fig. 4A, it was confirmed from the PL spectrum 40 of the light emitting material of the light emitting layer that the number of peaks of the exposure spectrum 41 for exposing the photosensitive drum is large. Furthermore, it was confirmed that all peaks of the exposure spectrum 41 overlap the absorption spectrum 42 of the photoreceptor.

Example 2

The exposure spectrum of an exposure head produced by the method described in Example 1, the absorption spectrum of the first organic compound layer (hole injection layer 3 and hole transport layer 4) between the positive electrode 2 as a first electrode and the light emitting layer 5, the absorption spectrum of the second organic compound layer (first electron transport layer 6, second electron transport layer 7, and electron injection layer 8) between the negative electrode 9 as a second electrode and the light emitting layer 5, and the absorption spectrum of the charge-generating material that was used in the photoreceptor as the absorption spectrum of the photoreceptor were respectively measured. As shown in Figs. 4A and 4B, it was confirmed that the maximum light emission peak wavelengths of the PL spectrum 40 and exposure spectrum 41 of the light emitting material were closer to the maximum absorption peak wavelength of the optical absorption spectrum 42 of the photoreceptor in the visible light region than the longest peak wavelengths of both the absorption spectrum 43 of the first organic compound layer and the absorption spectrum 44 of the second organic compound layer were.

According to the present disclosure, the photoreceptor can efficiently generate charge.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

**1.** An exposure head (28) comprising an organic light emitting element, wherein

the organic light emitting element includes a first electrode, a second electrode, an organic compound layer arranged between the first electrode and the second electrode, and a protection layer (125) covering the second electrode,
the organic compound layer includes a light emitting layer, and
the number of peaks in an exposure spectrum (41) emitted from the exposure head (28) is greater than the number of peaks in a PL spectrum (40) of a light emitting material included in the light emitting layer.

**2.** The exposure head (28) according to Claim 1, wherein the organic light emitting element has an optical resonator structure formed by the first electrode and the second electrode.

**3.** The exposure head (28) according to Claim 1 or 2, wherein the PL spectrum (40) includes two peaks.

**4.** The exposure head (28) according to Claim 3, wherein the exposure spectrum (41) includes five or more peaks.

**5.** The exposure head (28) according to Claim 1 or 2, wherein

the organic compound layer further includes a first organic compound layer located between the first electrode and the light emitting layer (5) and a second organic compound layer located between the light emitting layer and the second electrode,
the first electrode is a reflection electrode, and the second electrode is a light extraction electrode, and
the first organic compound layer has a thickness smaller than that of the second organic compound layer.

**6.** The exposure head (28) according to Claim 5, wherein a longest peak wavelength in an optical absorption spectrum of the second organic compound layer is farther from a maximum light emission peak wavelength of the PL spectrum (40) than a longest peak wavelength in an optical absorption spectrum of the first organic compound layer is.

**7.** The exposure head (28) according to Claim 1 or 2, wherein the protection layer (125) includes silicon nitride.

**8.** The exposure head (28) according to Claim 1 or 2, wherein the protection layer (125) includes a layer including aluminum oxide on a layer including silicon nitride.

**9.** The exposure head (28) according to Claim 1 or 2, wherein the organic light emitting element has a top emission type element structure arranged on an impermeable substrate (1).

**10.** An image-forming apparatus comprising a photoreceptor (27) and an exposure head (28) for exposing the photoreceptor (27), wherein,
the exposure head (28) is the exposure head (28) according to Claim 1 or 2.

**11.** The image-forming apparatus according to Claim 10, wherein all peaks of the exposure spectrum (41) overlap an optical absorption spectrum of the photoreceptor (27).

**12.** The image-forming apparatus according to Claim 10, wherein

the organic compound layer further includes a first organic compound layer located between the first electrode and the light emitting layer and a second organic compound layer located between the light emitting layer and the second electrode, and
a maximum light emission peak wavelength of the PL spectrum (40) is closer to a maximum absorption peak wavelength of an optical absorption spectrum of the photoreceptor (27) in a visible light region than a longest peak wavelength in an optical absorption spectrum of the first organic compound layer or a longest peak wavelength in an optical absorption spectrum of the second organic compound layer is.

**13.** The image-forming apparatus according to Claim 12, wherein the maximum light emission peak wavelength of the exposure spectrum (41) is closer to a maximum absorption peak wavelength of an optical absorption spectrum of the photoreceptor (27) in the visible light region than a longest peak wavelength in an optical absorption spectrum of the first organic compound layer and a longest peak wavelength in an optical absorption spectrum of the second organic compound layer are.

FIG. 1A

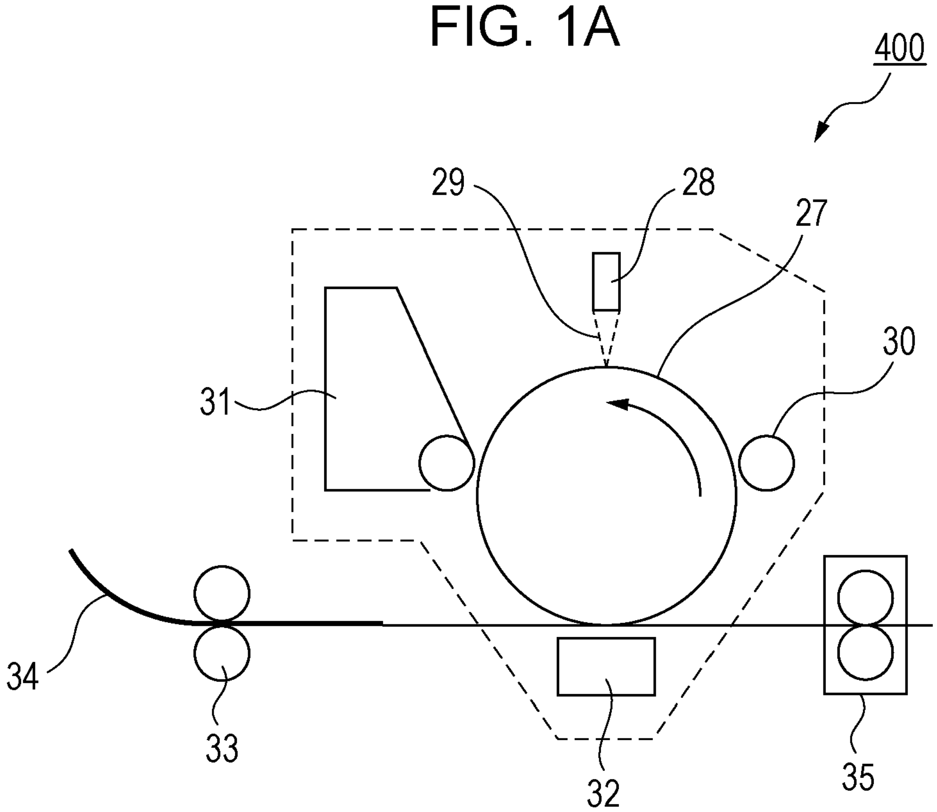


FIG. 1B

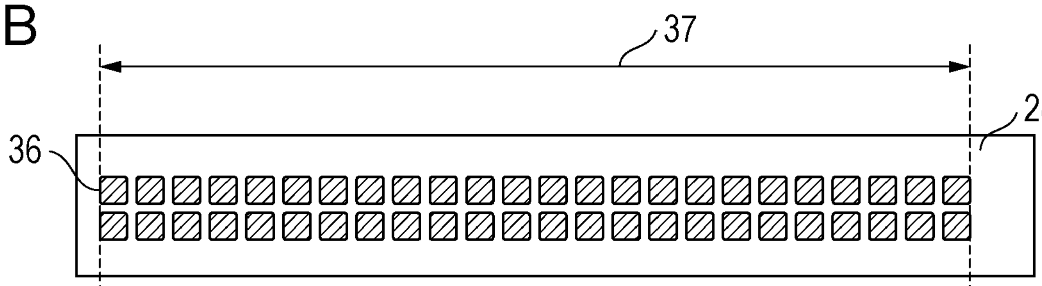


FIG. 1C

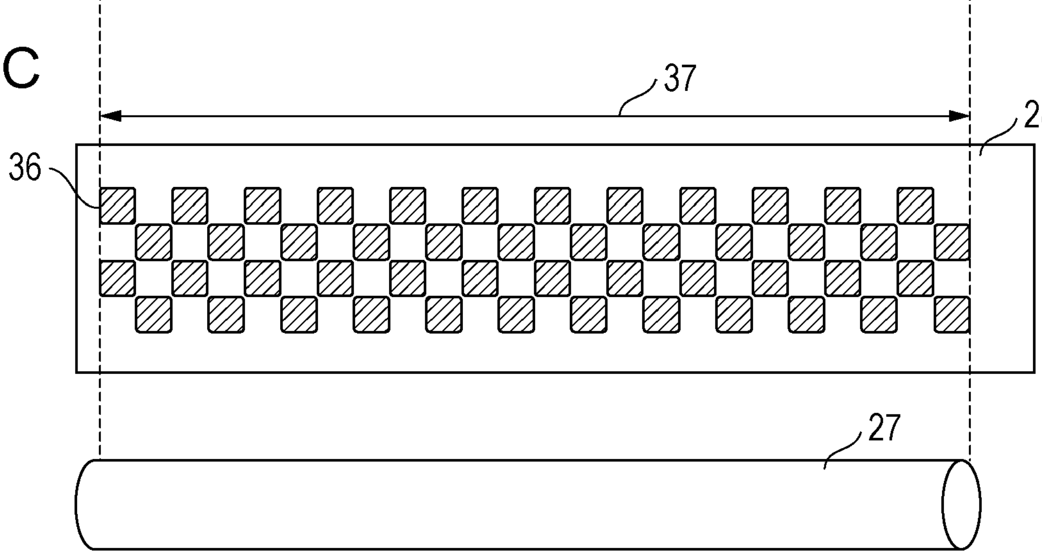

FIG. 2

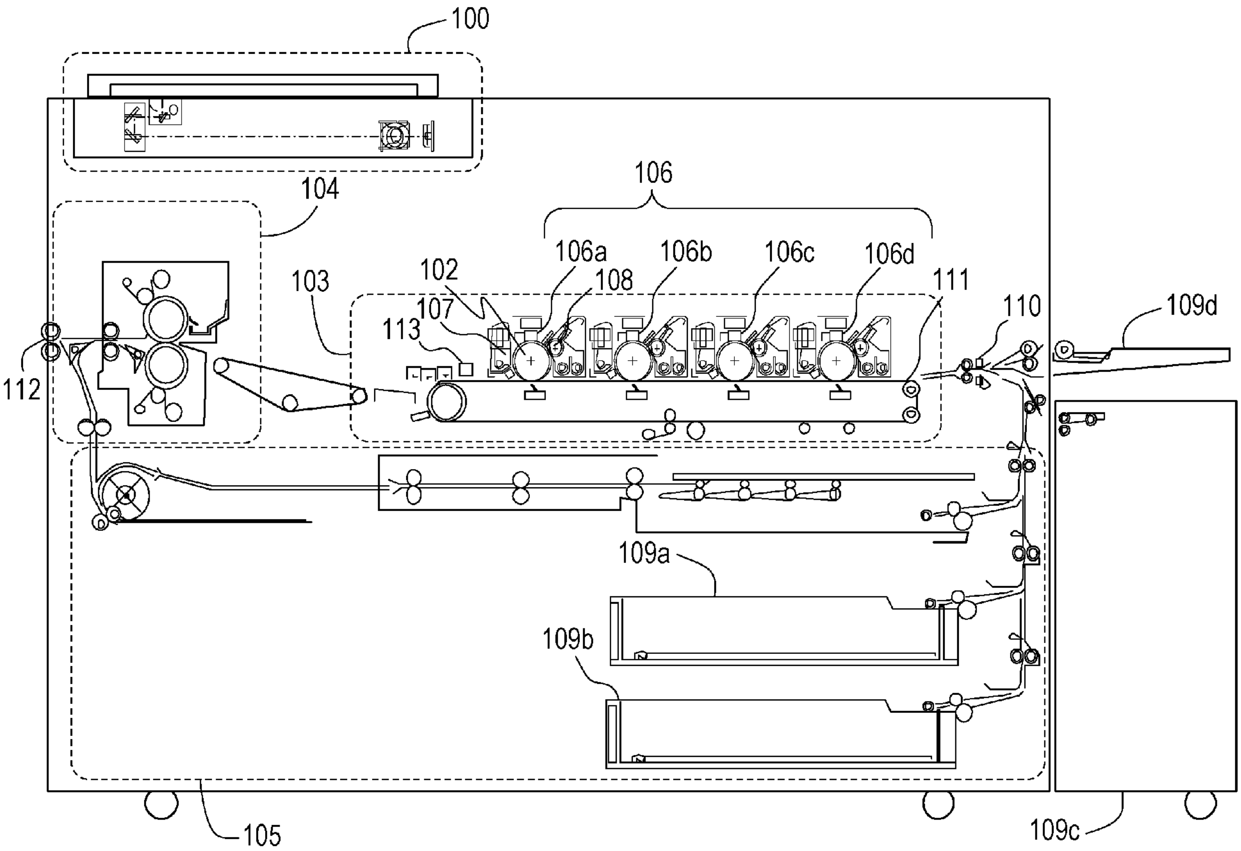
100
104
106
106a
106b
106c
106d
102
108
103
107
111
110
109d
113
112
109a
109b
105
109c

FIG. 3

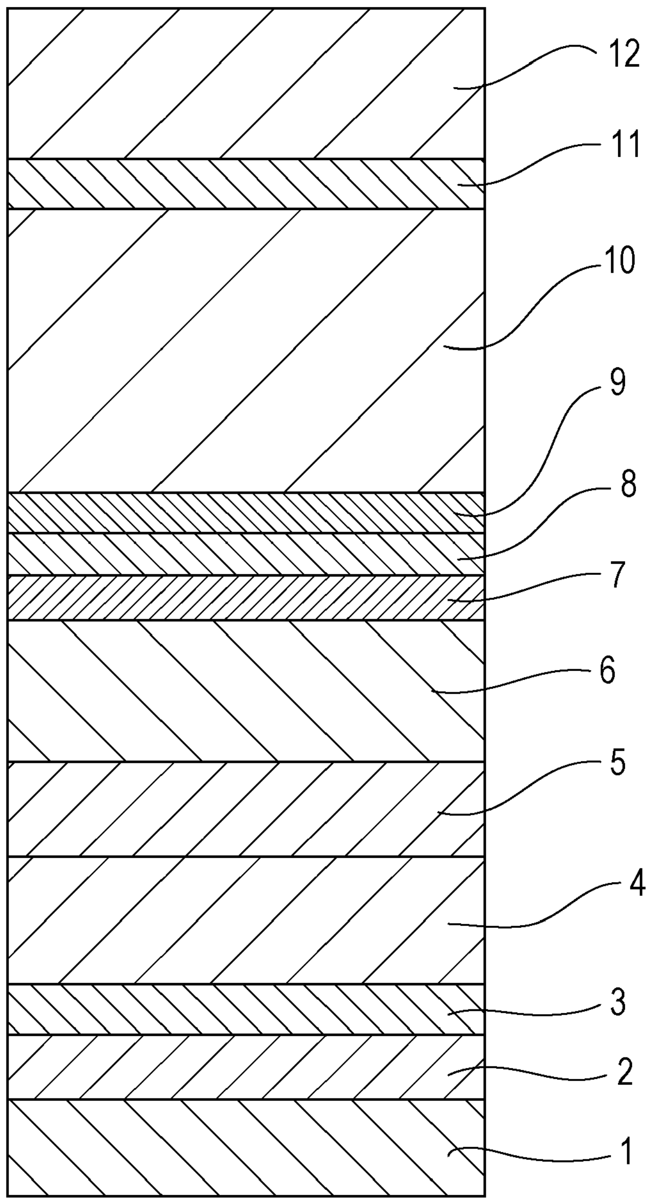

FIG. 4A

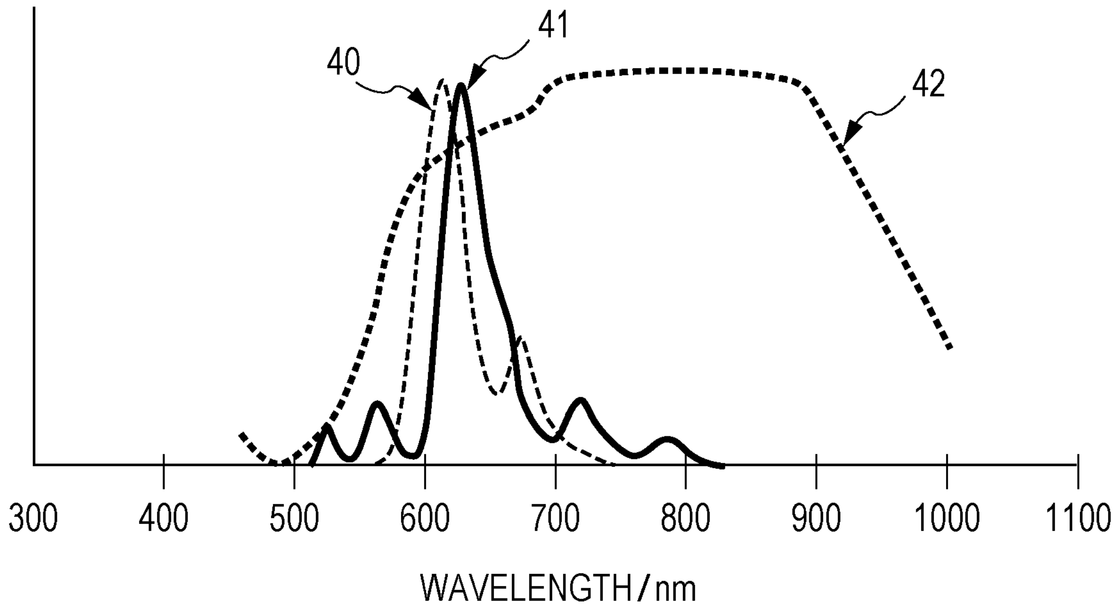
40
41
42
300
400
500
600
700
800
900
1000
1100
WAVELENGTH / nm

FIG. 4B

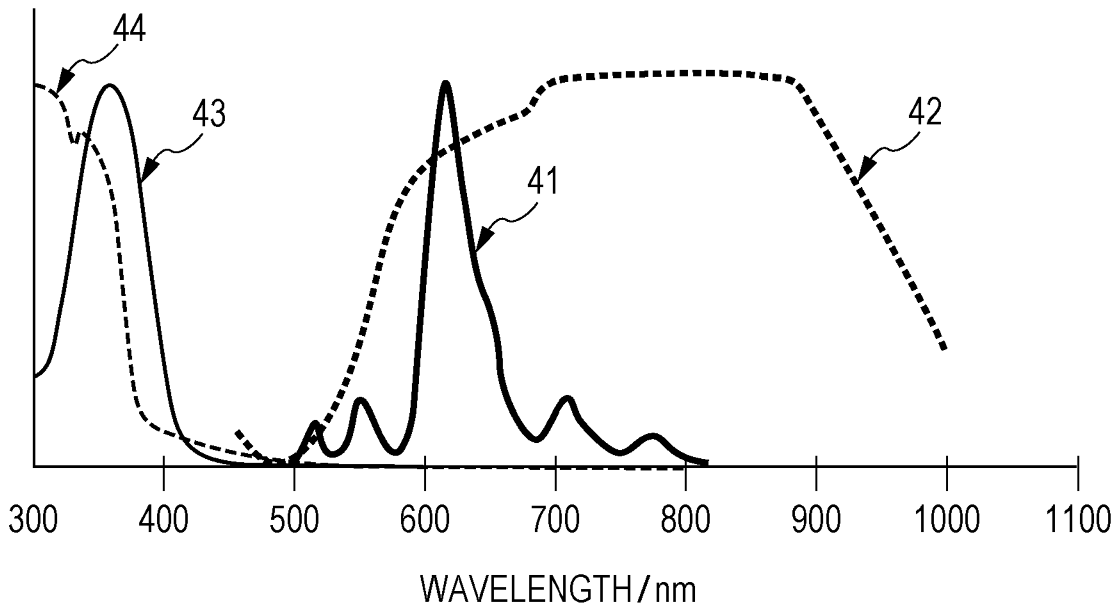
44
43
42
41
300
400
500
600
700
800
900
1000
1100
WAVELENGTH / nm

FIG. 5

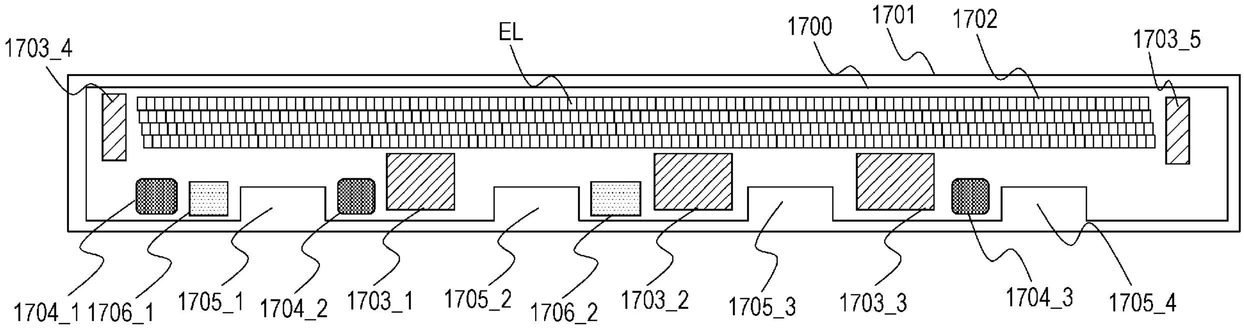
1703_4
EL
1700
1701
1702
1703_5
1704_1
1706_1
1705_1
1704_2
1703_1
1705_2
1706_2
1703_2
1705_3
1703_3
1704_3
1705_4

FIG. 6A

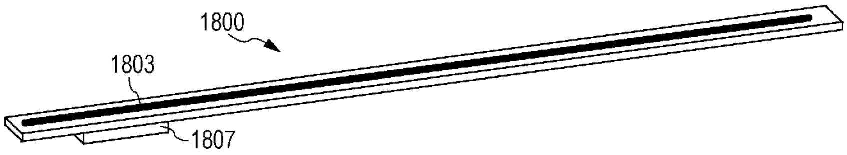


FIG. 6B

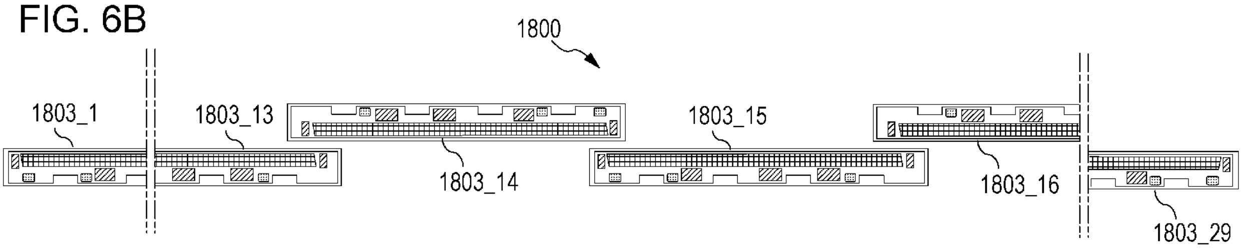


FIG. 6C

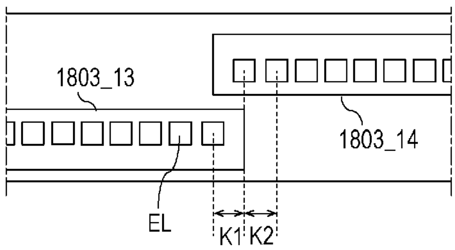

FIG. 7

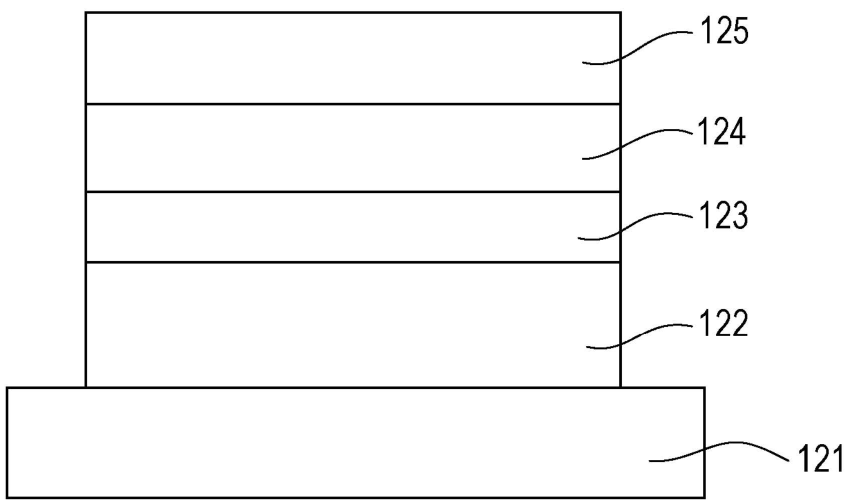

Europäisches Patentamt
European Patent Office
Office européen des brevets

# EUROPEAN SEARCH REPORT

Application Number
EP 25 16 1751

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2002/135664 A1 (MASHIMO SEIJI [JP] ET AL) 26 September 2002 (2002-09-26)<br>* paragraphs [0026], [0028], [0034]; claim 1; figures 5,7 * | 1-13 | INV.<br>H10K50/852<br>H10K50/844<br>B41J2/447<br>B41J2/45<br>G03G15/04<br>H10K59/80<br><br>ADD.<br>H10K102/00 |
| Y | US 2021/074945 A1 (KIM JAE-HYEON [KR] ET AL) 11 March 2021 (2021-03-11)<br>* paragraphs [0087], [0120], [0123]; figures 2B,3,4, 5A-5C; table 1 * | 1-13 | |
| Y | US 8 519 613 B2 (KAMATANI JUN [JP]; KAWATA ISAO [JP] ET AL.)<br>27 August 2013 (2013-08-27)<br>* figures 19,21,36,38; examples 1,2,3,4 * | 3 | |
| Y | US 2022/140008 A1 (FUKAGAWA TAKEFUMI [JP] ET AL) 5 May 2022 (2022-05-05)<br>* paragraph [0105]; figure 3 * | 7,8 | |
| A | US 10 651 422 B2 (CANON KK [JP])<br>12 May 2020 (2020-05-12)<br>* the whole document * | 1-13 | TECHNICAL FIELDS SEARCHED (IPC)<br>H10K<br>B41J<br>G03G |

The present search report has been drawn up for all claims

1

| Place of search | Date of completion of the search | Examiner |
|---|---|---|
| The Hague | 3 July 2025 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 16 1751

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2025

| Patent document cited in search report | Publication date | Patent family member(s) | Publication date |
|---|---|---|---|
| US 2002135664 A1 | 26-09-2002 | NONE | |
| US 2021074945 A1 | 11-03-2021 | CN 112447813 A | 05-03-2021 |
| | | KR 20210028855 A | 15-03-2021 |
| | | US 2021074945 A1 | 11-03-2021 |
| US 8519613 B2 | 27-08-2013 | CN 101752511 A | 23-06-2010 |
| | | EP 2200104 A2 | 23-06-2010 |
| | | JP 5164825 B2 | 21-03-2013 |
| | | JP 2010147332 A | 01-07-2010 |
| | | KR 20100071918 A | 29-06-2010 |
| | | US 2010157131 A1 | 24-06-2010 |
| | | US 2012085996 A1 | 12-04-2012 |
| US 2022140008 A1 | 05-05-2022 | CN 114429974 A | 03-05-2022 |
| | | JP 7226419 B2 | 21-02-2023 |
| | | JP 2022072089 A | 17-05-2022 |
| | | US 2022140008 A1 | 05-05-2022 |
| US 10651422 B2 | 12-05-2020 | CN 109892014 A | 14-06-2019 |
| | | JP 7016633 B2 | 07-02-2022 |
| | | JP 2018078095 A | 17-05-2018 |
| | | US 2019252644 A1 | 15-08-2019 |
| | | WO 2018079492 A1 | 03-05-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2022100479 A